# EUROPEAN PATENT SPECIFICATION

(11) **EP 2 166 616 B1**
(45) Date of publication and mention of the grant of the patent: **27.11.2013**
(21) Application number: 08791334.9
(22) Date of filing: 18.07.2008
(51) Int. Cl.: G06K 19/077, H01Q 1/36, H01Q 1/38, H01Q 1/42, H01Q 1/44, H01Q 7/00, H01Q 9/16, H01Q 13/10, H01Q 9/30, H05K 1/02, H05K 1/14, H05K 1/16

(54) **WIRELESS IC DEVICE**
DRAHTLOSE IC-VORRICHTUNG
DISPOSITIF CI SANS FIL

(30) Priority: 18.07.2007 JP 2007186391; 26.02.2008 JP 2008044338
(43) Date of publication of application: 24.03.2010
(60) Divisional application: 12195562.9
(73) Proprietor: Murata Manufacturing Co. Ltd., Nagaokakyo-shi, Kyoto 617-8555 (JP)
(72) Inventor: KATO, Noboru, Nagaokakyo-shi Kyoto 617-8555 (JP); ISHINO, Satoshi, Nagaokakyo-shi Kyoto 617-8555 (JP); KATAYA, Takeshi, Nagaokakyo-shi Kyoto 617-8555 (JP); KIMURA, Ikuhei, Nagaokakyo-shi Kyoto 617-8555 (JP); IKEMOTO, Nobuo, Nagaokakyo-shi Kyoto 617-8555 (JP); DOKAI, Yuya, Nagaokakyo-shi Kyoto 617-8555 (JP)
(74) Representative: Zimmermann, Tankred Klaus
(86) International application number: PCT/JP2008/063025
(87) International publication number: WO 2009/011423

(56) References cited:
- EP-A1- 2 012 258
- WO-A1-2004/025554
- WO-A1-2008/007606
- JP-A- 06 260 949
- JP-A- 09 093 029
- JP-A- 2000 209 013
- JP-A- 2000 349 680
- JP-A- 2001 339 226
- JP-A- 2002 150 245
- JP-A- 2002 280 821
- JP-A- 2003 078 333
- JP-A- 2003 188 620
- JP-A- 2004 040 597
- JP-A- 2004 336 250
- JP-A- 2004 519 916
- JP-A- 2005 005 866
- JP-A- 2007 159 083
- US-A1- 2006 043 198

## Description

### Technical Field

The present invention relates to radio IC devices, and particularly to a radio IC device including a radio IC used for an RFID (Radio Frequency Identification) system.

### Background Art

A RFID system has been developed for commodity management in recent years. In the RFID system, information is transmitted by non-contact communication between a reader/writer generating an induction field and an IC chip (may be referred to as IC tag or radio IC chip) storing commodity information and other information attached on the package or the like of the commodity.

Patent Document 1 discloses a transmitter/receiver unit including an IC chip-including radio IC device together with other chip components. In the transmitter/receiver unit, a circuit board on which the IC chip is mounted is enclosed in a shielding case, and an antenna element is further disposed on the circuit board.

Since the antenna element is disposed as an independent component different from the radio IC chip within the shielding case, however, the radio IC device becomes large in the shielding case and, consequently, increases the size of the transmitter/receiver unit. In order to avoid the increase in size, the antenna element is miniaturized. This however reduces the radiation characteristics of the antenna element to cause problems, such as the decrease in communication distance.
Patent Document 1: Japanese Unexamined Patent Application Publication No. 2002-232221

WO 2004/025554 A1 describes an RFID tag or label having a RFID tag module (comprising an electronic identification circuit and a coupling means) and an antenna structure coupled to the coupling means. The RFID tag module is separate from, separable or arranged to be severable from, the antenna structure. The tag module can be placed in or on an object and the antenna structure in or on packaging material for use with the object.

US 2006/043198 A1 describes an RFID device, such as an RFID tag or label, which includes a combined reactive coupler electrically coupling a transponder chip to an antenna. The combined reactive coupler includes a magnetic coupler and a capacitive coupler. The magnetic coupler and the reactive coupler may have respective coupling elements on both the interposer and on an antenna substrate.

EP 2 012 258 A1 which is a prior art document in accordance with Art. 54(3) EPC describes an article having attached thereto an electromagnetic-coupling module, which includes a wireless IC chip, and a feeder circuit board on which the wireless IC chip is mounted and in which a feeder circuit including a resonance circuit having a predetermined resonance frequency is provided. The article includes a radiation plate for radiating a transmission signal supplied from the feeder circuit of the electromagnetic-coupling module via electromagnetic coupling and for supplying a received reception signal to the feeder circuit via electromagnetic coupling.

### Summary of the Invention

It is an object of the present invention is to provide a radio IC device miniaturized without reducing the radiation characteristics.

This object is achieved by an apparatus according to claim 1.

The metal component doubling as the radiation plate is a ground electrode.

The feed circuit board may have a resonance circuit and/or a matching circuit. The radio IC is operated by a signal received by the radiation plate through the resonance circuit and/or the matching circuit, and the answer signal from the radio IC is radiated from the radiation plate to the outside through the resonance circuit and/or the matching circuit.

Since the metal component in the apparatus can be used as the radiation plate, another component is not required to be disposed as an antenna element. Consequently, the size of the apparatus is not increased. In addition, the metal components such as the case, the wiring electrode and the ground electrode are relatively large, and accordingly, desired radiation characteristics can be obtained. The apparatus used herein refers to an electronic apparatus in which the radio IC device is to be mounted, such as cellular phone. If the case of the apparatus is a shielding case made of a metal, the case can function as the radiation plate by itself. If the case is made of a nonconductive material, an electroconductive electrode film can be formed on the case so that the electrode film functions as the radiation plate.

### Advantages

The apparatus according to the present invention does not require that an antenna element be disposed as an additional independent component. Thus, the apparatus including the radio IC device can be miniaturized without degrading the radiation characteristics. The feed circuit board can be formed small. Accordingly, even a very small radio IC chip can be easily mounted on the small feed circuit board with a conventionally used IC mounter. Consequently, the packaging cost is reduced. All that is required to change the working frequency is to modify the design of the feed circuit.

### Brief Description of Drawings

[Fig. 1] Fig. 1 is a sectional view of a radio IC device according to a first example not forming part of the claimed invention.
[Fig. 2] Fig. 2 is a sectional view showing the connection between an electromagnetic coupling module and a wiring electrode.
[Fig. 3] Fig. 3 is a perspective view of a radio IC chip.
[Fig. 4] Fig. 4 is a perspective view showing the connection between the wiring electrode and a case.
[Fig. 5] Fig. 5 is a sectional view of a radio IC device according to a first example not forming part of the claimed invention.
[Fig. 6] Fig. 6 is a perspective view showing the connection from an electromagnetic coupling module and a wiring case.
[Fig. 7] Fig. 7 is an exploded perspective view of a feed circuit board containing a first example not forming part of the claimed invention of a resonance circuit.
[Fig. 8] Fig. 8 is a plan view a feed circuit board containing a second example not forming part of the claimed invention of the resonance circuit.
[Fig. 9] Fig. 9 is a perspective view of a radio IC device according to a third example not forming part of the claimed invention.
[Fig. 10] Fig. 10 is a perspective view of a radio IC device according to a fourth example not forming part of the claimed invention.
[Fig. 11] Fig. 11 is a perspective view of a radio IC device according to a fifth example not forming part of the claimed invention.
[Fig. 12] Fig. 12 is a perspective view of a radio IC device according to a sixth example not forming part of the claimed invention.
[Fig. 13] Fig. 13 is a perspective view of a radio IC device according to a seventh example not forming part of the claimed invention.
[Fig. 14] Fig. 14 is a perspective view of a radio IC device according to an eighth example not forming part of the claimed invention.
[Fig. 15] Fig. 15 is a perspective view of a radio IC device according to a ninth example not forming part of the claimed invention.
[Fig. 16] Fig. 16 is a perspective view of a radio IC device according to a tenth example not forming part of the claimed invention.
[Fig. 17] Fig. 17 is an exploded perspective view of a radio IC device according to an eleventh example not forming part of the claimed invention.
[Fig. 18] Fig. 18 is a perspective view of the eleventh example not forming part of the claimed invention.
[Fig. 19] Fig. 19 is a sectional view of the eleventh example not forming part of the claimed invention.
[Fig. 20] Fig. 20 is a perspective view of a radio IC device according to a twelfth example not forming part of the claimed invention.
[Fig. 21] Fig. 21 is a perspective view of a radio IC device according to a 13th example not forming part of the claimed invention.
[Fig. 22] Fig. 22 is a perspective view of a radio IC device according to a 14th example not forming part of the claimed invention.
[Fig. 23] Fig. 23 is a plan view of a radio IC device according to a 15th example not forming part of the claimed invention.
[Fig. 24] Fig. 24 is a plan view of the radio IC device according to the 15th example not forming part of the claimed invention in the course manufacture.
[Fig. 25] Fig. 25 is a plan view of a radio IC device according to a 16th example not forming part of the claimed invention.
[Fig. 26] Fig. 26 is a plan view of a radio IC device according to a 17th example not forming part of the claimed invention.
[Fig. 27] Fig. 27 is a plan view of a radio IC device according to an 18th example not forming part of the claimed invention.
[Fig. 28] Fig. 28 is a plan view of a radio IC device according to a 19th example not forming part of the claimed invention.
[Fig. 29] Fig. 29 is a plan view of a radio IC device according to a 20th example not forming part of the claimed invention.
[Fig. 30] Fig. 30 is a plan view of a radio IC device according to a 21st example not forming part of the claimed invention.
[Fig. 31] Fig. 31 is a plan view illustrating the operation principle of the radio IC device according to the 21st example not forming part of the claimed invention.
[Fig. 32] Fig. 32 is a sectional view taken along line A-A in Fig. 30.
[Fig. 33] Fig. 33 is a sectional view of a radio IC device according to a 22nd example not forming part of the claimed invention.
[Fig. 34] Fig. 34 is a sectional view of a radio IC device according to a 23rd example not forming part of the claimed invention.
[Fig. 35] Fig. 35 is a sectional view of a radio IC device according to a 24th example not forming part of the claimed invention.
[Fig. 36] Fig. 36 is an assembly diagram of a radio IC device according to a 25th example not forming part of the claimed invention.
[Fig. 37] Fig. 37 is a plan view of a radio IC device according to a 26th example not forming part of the claimed invention.
[Fig. 38] Fig. 38 is a plan view of a radio IC device according to a 27th example not forming part of the claimed invention.
[Fig. 39] Fig. 39 is a plan view of a radio IC device according to a 28th example not forming part of the claimed invention.
[Fig. 40] Fig. 40 is a plan view of a radio IC device according to a 29th example not forming part of the claimed invention.
[Fig. 41] Fig. 41 is a plan view of a radio IC device according to a 30th example not forming part of the claimed invention.
[Fig. 42] Fig. 42 is a plan view of a radio IC device according to a 31st example not forming part of the claimed invention.
[Fig. 43] Fig. 43 is a plan view of a radio IC device according to a 32nd example not forming part of the claimed invention.
[Fig. 44] Fig. 44 is a plan view of a radio IC device according to a 33rd example not forming part of the claimed invention.
[Fig. 45] Fig. 45 is a sectional view taken along line B-B in Fig. 44.
[Fig. 46] Fig. 46 is a sectional view of a radio IC device according to a 34th example not forming part of the claimed invention.
[Fig. 47] Fig. 47 is a sectional view of a radio IC device according to a 35th example not forming part of the claimed invention.
[Fig. 48] Fig. 48 is a plan view of a radio IC device according to a 36th example not forming part of the claimed invention.
[Fig. 49] Fig. 49 is a plan view of a radio IC device according to a 37th example not forming part of the claimed invention.
[Fig. 50] Fig. 50 is a plan view of a radio IC device according to a 38th example not forming part of the claimed invention.
[Fig. 51] Fig. 51 is a plan view of a radio IC device according to a 39th example not forming part of the claimed invention.
[Fig. 52] Fig. 52 is a plan view of a radio IC device according to a 40th example not forming part of the claimed invention.
[Fig. 53] Fig. 53 is a plan view of a radio IC device according to a 41st example not forming part of the claimed invention.
[Fig. 54] Fig. 54 is a plan view of a radio IC device according to a 42nd example not forming part of the claimed invention.
[Fig. 55] Fig. 55 is a sectional view taken along line C-C in Fig. 54.
[Fig. 56] Fig. 56 is a plan view of a radio IC device according to a 43rd example not forming part of the claimed invention.
[Fig. 57] Fig. 57 is a plan view of a radio IC device according to a 44th example not forming part of the claimed invention.
[Fig. 58] Fig. 58 is a plan view of a radio IC device according to a 45th example not forming part of the claimed invention.
[Fig. 59] Fig. 59 is a plan view of a radio IC device according to a 46th example not forming part of the claimed invention.
[Fig. 60] Fig. 60 is a plan view of a radio IC device according to a 47th example not forming part of the claimed invention.
[Fig. 61] Fig. 61 is a plan view of a radio IC device according to a 48th example not forming part of the claimed invention.
[Fig. 62] Fig. 62 is a plan view of a radio IC device according to a 49th example not forming part of the claimed invention.
[Fig. 63] Fig. 63 is a plan view illustrating the operation principle of the radio IC device according to the 49th embodiment.
[Fig. 64] Fig. 64 is a perspective view of an electromagnetic coupling module of the radio IC device according to the 49th example not forming part of the claimed invention.
[Fig. 65] Fig. 65 is a sectional view of the electromagnetic coupling module.
[Fig. 66] Fig. 66 is a plan view of a radio IC device according to a 50th example not forming part of the claimed invention.
[Fig. 67] Fig. 67 is a plan view of a radio IC device according to a 51st example not forming part of the claimed invention.
[Fig. 68] Fig. 68 is a plan view of a radio IC device according to a 52nd example not forming part of the claimed invention.
[Fig. 69] Fig. 69 is a plan view of a radio IC device according to a 53rd example not forming part of the claimed invention.
[Fig. 70] Fig. 70 is a plan view of a radio IC device according to a 54th example not forming part of the claimed invention.
[Fig. 71] Fig. 71 is a plan view of a radio IC device according to a 55th example not forming part of the claimed invention.
[Fig. 72] Fig. 72 is a plan view of a radio IC device according to a 56th example not forming part of the claimed invention.
[Fig. 73] Fig. 73 is a plan view of an electromagnetic coupling module of the radio IC device according to the 56th example not forming part of the claimed invention.
[Fig. 74] Fig. 74 is a plan view of an electromagnetic coupling module according to a modification, used in a radio IC device**.**
[Fig. 75] Fig. 75 is a plan view of an apparatus according to an embodiment of the present invention.

### Reference Numerals

5: radio IC chip
10, 40, 130, 160, 190, 200: feed circuit board
20, 100, 120, 180: printed wiring board
21a, 21b, 22a, 22b: second wiring electrode
23,101,121,181: ground electrode
24, 25, 103, 143, 173, 183: loop electrode
28, 50-54: case
28': electrode film
36: wiring cable (first wiring electrode)
109: shielding case
110: connector
111: coaxial cable
112: slot case
113: battery
122: power line
129: power supply cable
131, 167, 191, 195, 201: coil
132, 192: matching circuit/resonance circuit
140, 170: auxiliary substrate
146: signal line
152: antenna wire
L, L1, L2, L11, L12, L13: inductance element
C, C1, C2: capacitance element

### Best Modes for Carrying Out the Invention

Embodiments and examples will now be described with reference to the attached drawings. The same parts and portions in the drawings are designated by the same reference numerals, and the same description is not repeated.

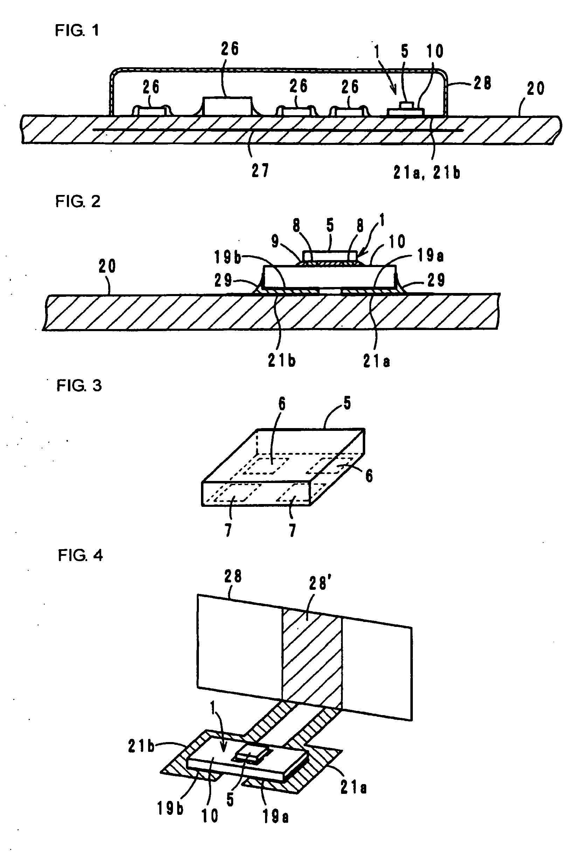

### (First example, Figs. 1 to 4)

Fig. 1 shows essential parts of an electronic apparatus including a radio IC device according to a first example of the present invention. The electronic apparatus contains a printed wiring board 20 on which an electromagnetic coupling module 1 and other electronic components 26 such as a chip resistor and a chip capacitor, are mounted. The printed wiring board also includes a shielding electrode 27 therein.

The electromagnetic coupling module 1 includes a radio IC chip 5 processing a transmitted/received signal having a predetermined frequency and a feed circuit board 10 on which the radio IC chip 5 is disposed, as shown in Fig. 2. A shielding case 28 of an apparatus doubles as a radiation plate functioning as an antenna element, and is electrically continued to second wiring electrodes 21a and 21b (see Figs. 2 and 4) magnetically coupled to the electromagnetic coupling module 1 on the printed wiring board 20. The electromagnetic coupling module 1 and the radiation plate (shielding case 28) define the radio IC device.

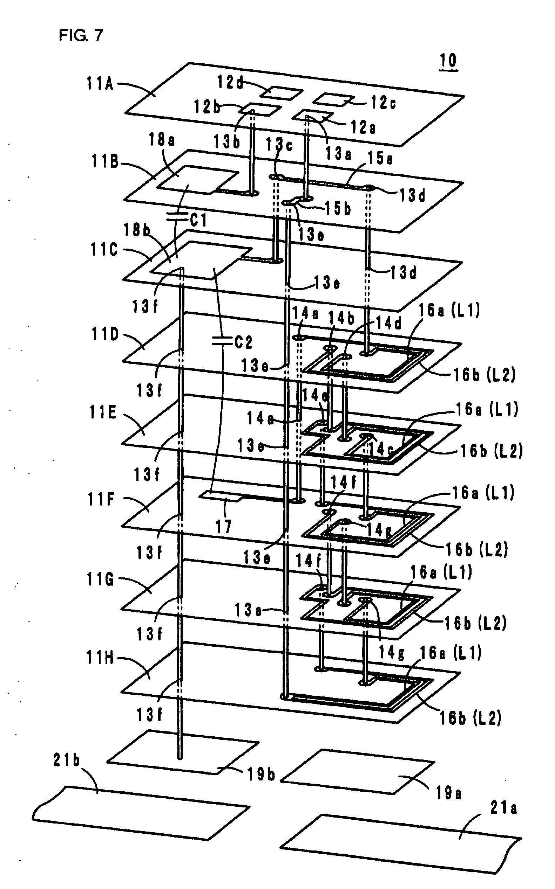

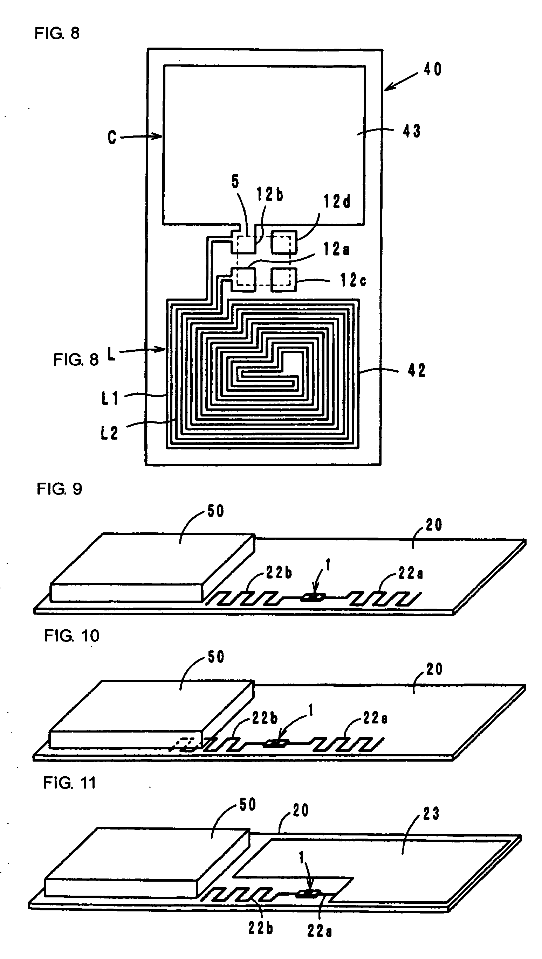

The radio IC chip 5 includes a clock circuit, a logic circuit, a memory circuit or the like, and stores necessary information. On the rear surface of the radio IC chip, input/output terminal electrodes 6 and packaging terminal electrodes 7 are disposed, as shown in Fig. 3. The input/output terminal electrodes 6 are electrically connected to electrodes 12a and 12b (see Figs. 7 and 8) disposed on the surface of the feed circuit board 10 through metal bumps 8. The packaging terminal electrodes 7 are electrically connected to electrodes 12c and 12d through metal bumps 8. The material of the metal bumps 8 can be Au, Ag, solder or the like.

A protective film 9 is provided between the surface of the feed circuit board 10 and the rear surface of the radio IC chip 5 to enhance the bonding strength between the feed circuit board 10 and the radio IC chip 5 and to protect the bumps 8.

The shielding case 28 is made of a metal and disposed so as to cover the electromagnetic coupling module 1 and the electronic components 26 on the printed wiring board 20. In addition, the shielding case functions as a radiation plate of the electromagnetic coupling module 1, as will be described below. If the case 28 is made of a nonconductive material, an electroconductive electrode film 28' is formed on the internal surface of the case 28, as indicated by oblique lines shown in Fig. 4, and the electrode film 28' functions as the radiation plate.

The feed circuit board 10 contains a feed circuit (including a resonance circuit having an inductance element and a matching circuit, not shown in Fig. 2), and is provided with external electrodes 19a and 19b from the rear surface to the sides. Also, the connection electrodes 12a and 12d (see Figs. 7 and 8) are formed on the surface of the feed circuit board 10. The external electrodes 19a and 19b are electromagnetically coupled to the resonance circuit contained in the feed circuit board 10 and electrically connected to the second wiring electrodes 21a and 21b with an electroconductive adhesive 29. The electrical connection may be established by soldering.

More specifically, the feed circuit board 10 contains a resonance circuit having a predetermined resonance frequency that transmits a signal having the predetermined frequency generated from the radio IC chip 5 to the shielding case 28 (or the electrode film 28') through the external electrodes 19a and 19b and the wiring electrodes 21a and 21b, and supplies a signal having the predetermined frequency selected from the signals received by the shielding case 28 (or the electrode film 28') to the radio IC chip 5. In the radio IC device, the radio IC chip 5 operates according to the signal received by the shielding case 28 (or the electrode film 28'), and an answer signal from the radio IC chip 5 is radiated from the shielding case 28 (or the electrode film 28').

In the electromagnetic coupling module 1, the external electrodes 19a and 19b disposed on the surface of the feed circuit board 10 are electromagnetically coupled to the resonance circuit contained in the feed circuit board 10 and electrically continued to the shielding case 28 functioning as an antenna. The electromagnetic coupling module 1 does not require a relatively large antenna element separately, and accordingly can be small. Since the feed circuit board 10 has been miniaturized, the radio IC chip 5 can be mounted on a miniaturized feed circuit board 10 by a conventionally used IC mounter or the like, and thus the packaging cost can be reduced. All that is required to change the working frequency is to modify the design of the feed circuit, and the shielding case 28 may be used without being modified. The shielding case 28 is relatively large and can ensure desired radiation characteristics.

Preferably, the electroconductive adhesive 29 for bonding the external electrodes 19a and 19b with the second wiring electrodes 21a and 21b contains metal particles. Such an adhesive 29 exhibits a small difference in thermal expansion from the external electrodes 19 and 19b and the wiring electrodes 21a and 21b when they undergo temperature changes, and accordingly the bonding reliability is enhanced.

The second wiring electrodes 21a and 21b may be formed within the printed wiring board 20. In this instance, the second wiring electrodes 21a and 21b are electrically connected to the electrodes on the surface of the wiring board 20 through a known via hole conductor. The printed wiring board 20 may be a ceramic multilayer substrate or a resin substrate.

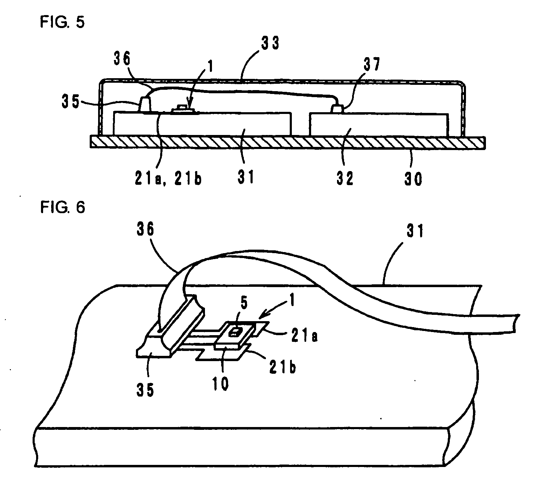

### (Second example, see Figs. 5 and 6)

Fig. 5 shows essential parts of an electronic apparatus including a radio IC device according to a second example of the present invention. The electronic apparatus contains a plurality of printed wiring boards 31 and 32 covered with a case 33. The printed wiring boards 31 and 32 are disposed on a substrate 30. One printed wiring board 31 is provided with an electromagnetic coupling module 1 and other electronic components thereon, and the other printed wiring board 32 is provided with other electronic components thereon.

In the electromagnetic coupling module 1, the external electrodes 19a and 19b (see Fig. 2) of the electromagnetic coupling module 1 are electrically connected to second wiring electrodes 21a and 21b disposed on the printed wiring board 31, as shown in Fig. 6. The wiring electrodes 21a and 21b are connected to one end of a wiring cable 36 acting as a first wiring electrode provided to a known wiring connector 35. The other end of the wiring cable 36 is fixed to a securing member 37 disposed on the printed wiring board 32 and is electrically open.

In the second example, the wiring cable 36 between the wiring boards 31 and 32 functions as a radiation plate of the electromagnetic coupling module 1. Thus, an RFID system is defined, and transmits and receives high-frequency signals to and from a reader/writer. Thus, the same effects are produced as in the first example.

### (First example of Resonance Circuit, Fig. 7)

Fig. 7 shows a resonance circuit according to a first example, in which the feed circuit board 10 contains the resonance circuit. The feed circuit board 10 is prepared by stacking dielectric ceramic sheets 11A to 11H, and pressing and firing the stack. The sheet 11A is provided with connection electrodes 12a and 12b, electrodes 12c and 12d, and via hole conductors 13a and 13b. The sheet 11B is provided with a capacitor electrode 18a, conductor patterns 15a and 15b, and via hole conductors 13c to 13e. The sheet 11C is provided with a capacitor electrode 18b and via hole conductors 13d to 13f. The sheet 11D is provided with conductor patterns 16a and 16b and via hole conductors 13e, 13f, 14a, 14b and 14d. The sheet 11E is provided with conductor patterns 16a and 16b and via hole conductors 13e, 13f, 14a, 14c and 14e. The sheet 11F is provided with a capacitor electrode 17, conductor patterns 16a and 16b and via hole conductors 13e, 13f, 14f and 14g. The sheet 11G is provided with conductor patterns 16a and 16b and via hole conductors 13e, 13f, 14f and 14g. The sheet 11H is provided with conductor patterns 16a and 16b and a via hole conductor 13f.

By stacking these sheets 11A to 11H, a conductor pattern 16a is formed in a spiral manner continuing through the via hole conductors 14c, 14d and 14g, thus defining an inductance element L1, and a conductor pattern 16b is formed in a spiral manner continuing through the via hole conductors 14b, 14e and 14f, thus defining an inductance element L2. Also, a capacitance element C1 is defined by capacitor electrodes 18a and 18b, and a capacitance element C2 is defined by capacitor electrodes 18b and 17.

One end of the inductance element L1 is connected to the capacitor electrode 18b through the via hole conductor 13d, conductor pattern 15a and the via hole conductor 13c, and one end of the inductance element L2 is connected to the capacitor electrode 17 through the via hole conductor 14a. The other ends of the inductance elements L1 and L2 are brought together on the sheet 11H and connected to the connection electrode 12a through the via hole conductor 13e, the conductor pattern 15b and the via hole conductor 13a. In addition, the capacitor electrode 18a is electrically connected to the connection electrode 12b through the via hole conductor 13b.

The connection electrodes 12a and 12b are electrically connected to the input/output terminal electrodes 6 (see Fig. 3) of the radio IC chip 5 through the metal bumps 8 (see Fig. 2). The electrodes 12c and 12d are connected to the packing terminal electrodes 7 of the radio IC chip 5.

In addition, the external electrodes 19a and 19b are formed on the rear surface of the feed circuit board 10 by applying a conductive paste. The external electrode 19a is coupled to the inductance elements L (L1 and L2) by a magnetic field, and the external electrode 19b is connected to the capacitor electrode 18b through the via hole conductor 13f. The external electrodes 19a and 19b are electrically connected to the wiring electrodes 21a and 21b, as described above.

In the resonance circuit, the inductance elements L1 and L2 are arranged in such a manner that two conductor patterns 16a and 16b are disposed in parallel. The two conductor patterns 16a and 16b have different line lengths from each other to have different resonance frequencies. Thus, the radio IC device can be used for a wide range of frequencies.

The ceramic sheets 11A to 11H may be made of a magnetic ceramic material, and the feed circuit board 10 can be easily produced by a known process for forming a multilayer substrate, such as stacking sheets or printing into a thick film.

The sheets 11A to 11H may be flexible sheets made of, for example, a dielectric material such as polyimide or liquid crystal polymer. Electrodes or conductors are formed on such flexible sheets by a thick film forming process, and then the sheets are stacked one on top of another and thermally compressed into a multilayer composite. Thus, the inductance elements L1 and L2 and the capacitance elements C1 and C2 may be disposed within the circuit board.

In the feed circuit board 10, the inductance elements L1 and L2 and the capacitance elements C1 and C2 are disposed at different positions when viewed from above. The inductance elements L1 and L2 are coupled to the external electrode 19a (wiring electrode 21a) by a magnetic field, and the capacitance element C1 is coupled to the external electrode 19b (wiring electrode 21b) by an electric field.

Thus, the electromagnetic coupling module 1 including the radio IC chip 5 on the feed circuit board 10 receives high-frequency signals (for example, UHF frequencies) radiated from a reader/writer (not shown) with a shielding case 28 or a wiring cable 36, so that the resonance circuit coupled to the external electrodes 19a and 19b through the wiring electrodes 21a and 21b by a magnetic field and an electric field resonates to supply only a received signal having a predetermined frequency to the radio IC chip 5. A predetermined energy is extracted from the received signal. The energy is used as a driving source to match the information stored in the radio IC chip 5 with a predetermined frequency by a resonance circuit, and to transmit the information to the shielding case 28 or the wiring cable 36 through the external electrodes 19a and 19b and the wiring electrodes 21a and 21b, and further transmit or transfer the information to the reader/writer from the case 28 or the cable 36.

The resonance frequency characteristics of the feed circuit board 10 depend on the resonance circuit including the inductance elements L1 and L2 and the capacitance elements C1 and C2. The resonance frequency of the signal radiated from the shielding case 28 or the wiring cable 36 substantially depends on the self resonant frequency of the resonance circuit. It is accordingly not necessary to redesign the resonance circuit even if the shielding case 28 or the wiring cable 36 is changed in shape or material. Thus, the resonance circuit can be applied to various electronic apparatuses.

The resonance circuit doubles as a matching circuit for matching the impedances between the radio IC chip 5 and the radiation plate (shielding case 28 or wiring cable 36). The feed circuit board 10 may include a matching circuit provided in addition to the resonance circuit including the inductance elements and the capacitance elements (in this sense, the resonance circuit may be referred to as matching circuit). The design for a resonance circuit doubling as a matching circuit tends to be complicated. A structure in which a matching circuit is provided apart from the resonance circuit allows the resonance circuit and the matching circuit to be designed independently. The resonance circuit may be replaced with a matching circuit. The resonance circuit may be designed in view of the shape and size of the radiation plate, or the shielding case 28 or the wiring cable 36. Although this requires that the feed circuit board 10 be precisely mounted at a correct position, the radiation characteristics of the resulting radio IC device can be enhanced.

### (Second example of Resonance Circuit, Fig. 8)

Fig. 8 shows a resonance circuit according to a second example, in which the resonance circuit is disposed on a feed circuit board 40. This feed circuit board 40 is made of a flexible PET film or the like, and on which a spiral conductor pattern 42 defining inductance elements L and a capacitor electrode 43 defining a capacitance element C are disposed. Electrodes 12a and 12b extending from the conductor pattern 42 and the capacitor electrode 43 are electrically connected to the terminal electrodes 6 of the radio IC chip 5. Electrodes 12c and 12d formed on the circuit board 40 act as terminal ground electrodes and are electrically connected to the terminal electrodes 7 of the radio IC chip 5.

The feed circuit board 40 is the same as that of the first example in that the inductance elements L and the capacitance element C define a resonance circuit and are coupled to the respectively opposing second wiring electrodes 21a and 21b by a magnetic field and an electric field to transmit and receive a high-frequency signal having a predetermined frequency. In the second example, in particular, the feed circuit board 40 made of a flexible film leads to a thin electromagnetic coupling module 1. The inductances of the inductance elements L can be varied by varying the line width or the line pitch of the conductor pattern 42, and thus the resonance frequency can be precisely adjusted.

In the second example as well, the conductor pattern 42 defining the inductance elements L includes two spiral lines that are connected to each other at the center of the spirals. The two lines of the conductor pattern 42 have respective inductances L1 and L2 and their resonance frequencies can be set to different values. Thus, the resulting radio IC device can be used in a wide range of frequencies as that of the first example.

### (Third example, Fig. 9)

In the radio IC device according to a third example, second wiring electrodes 22a and 22b are formed in a meandering manner on the printed wiring board 20 of an electronic apparatus. The electromagnetic coupling module 1 is mounted on one end of each of the wiring electrodes 22a and 22b, as shown in Fig. 9. A metal case 50 of a battery or liquid crystal panel is disposed close to the electrode 22b on the printed wiring board 20. The electromagnetic coupling module 1 is coupled to the wiring electrodes 22a and 22b in the same manner as in the first and the second example.

In the third example, the second wiring electrodes 22a and 22b function as the radiation plate, and the metal case 50 by the wiring electrode 22b is coupled to the wiring electrode 22b to function as the radiation palate. The wiring electrodes 22a and 22b themselves can function as the radiation plate, and, in addition, the metal case 50 is also used as the radiation plate. Consequently, the radiation characteristics and the antenna gain are enhanced. The radio IC device of the third example can function without the metal case 50. By matching the resonance frequency of the metal case 50 to the working frequency of the radio IC device, the antenna gain can further be enhanced.

### (Fourth example, Fig. 10)

The radio IC device according to a fourth example has the same structure as that of the third example except that part of the metal case 50 used in the third example is disposed on the wiring electrode 22b, as shown in Fig. 10. The fourth example produces the same effects as the third example. Since the metal case 50 overlaps the wiring electrode 22b, particularly the degree of their coupling is increased.

### (Fifth example, Fig. 11)

In the radio IC device according to a fifth example, the wiring electrode 22a is electrically connected to a ground electrode 23 disposed on the printed wiring board 20, and the other wiring electrode 22b is disposed close to the metal case 50, as shown in Fig. 11.

The ground electrode 23 may be contained in the printed wiring board 20. In this instance, the wiring electrode 22a may be connected to the ground electrode 23 through a via-hole conductor, or may be formed in a meandering manner as shown in Fig. 9 and overlap the ground electrode 23.

In the fifth example, the wiring electrode 22b and the metal case 50 function as a radiation plate, and, in addition, the ground electrode 23 connected to the wiring electrode 22a also function as a radiation plate. Since the ground electrode 23 has a large area, the radiation characteristics and the antenna gain are enhanced.

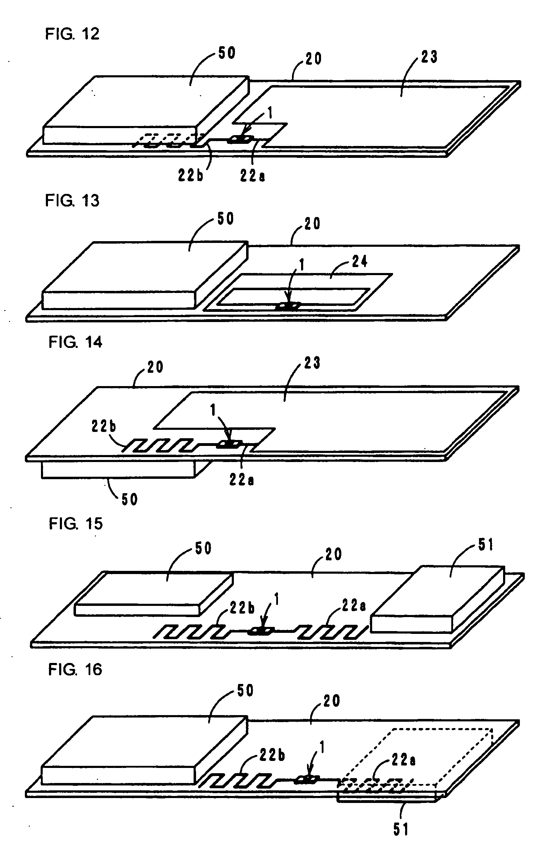

### (Sixth example, Fig. 12)

The radio IC device according to a sixth example has the same structure as that of the fifth example except that part of the metal case 50 used in the fifth example is disposed on the wiring electrode 22b, as shown in Fig. 12. The sixth example produces the same effects as the fifth example. Since the metal case 50 overlaps the wiring electrode 22b, particularly the degree of their coupling is increased.

### (Seventh example, Fig. 13)

In the radio IC device according to a seventh example, a loop electrode 24 acting as the second wiring electrode is disposed on the printed wiring board 20, and the electromagnetic coupling module 1 is disposed on both ends of the line of the loop electrode 24, as shown in Fig. 13. The metal case 50 is disposed close to the loop electrode 24 on the printed wiring board 20. The electromagnetic coupling module 1 is coupled to the loop electrodes 24 in the same manner as in the first and the second example.

In the seventh example, the loop electrode 24 functions as a radiation plate, and the metal case 50 coupled to the loop electrode 24 also functions as a radiation plate. In particular, the loop electrode 24 can match the impedances between the radio IC chip 5 and the radiation plate, and thus enhances the signal transmission efficiency between the radio IC chip 5 and the radiation plate without requiring an additional matching portion.

### (Eight example, Fig. 14)

In the radio IC device according to an eighth example, the metal case 50 used in the sixth example (see Fig. 12) is disposed on the rear surface of the printed wiring board 20, as shown in Fig. 14. Part of the metal case 50 is coupled to the wiring electrode 22b with the printed wiring board 20 therebetween. The other structure is the same as in the sixth example. The eighth example produces the same effects as the sixth example. Since the metal case 50 is disposed on the rear surface of the printed wiring board 20, the ground electrode 23 can be formed with a large area.

### (Ninth example, Fig. 15)

In the radio IC device according to a ninth example, another metal case 51 is added close to the wiring electrode 22a on the surface of the printed wiring board 20 of the third example (see Fig. 9), as shown in Fig. 15. The metal case 51 is coupled to the wiring electrode 22a to function as a radiation plate, and, thus, the antenna gain is further enhanced.

### (Tenth example, Fig. 16)

In the radio IC device according to a tenth example, the metal case 51 used in the ninth example is disposed on the rear surface of the printed wiring board 20, as shown in Fig. 16. In this instance, the metal case 51 is coupled to the wiring electrode 22a with the printed wiring board 20 therebetween.

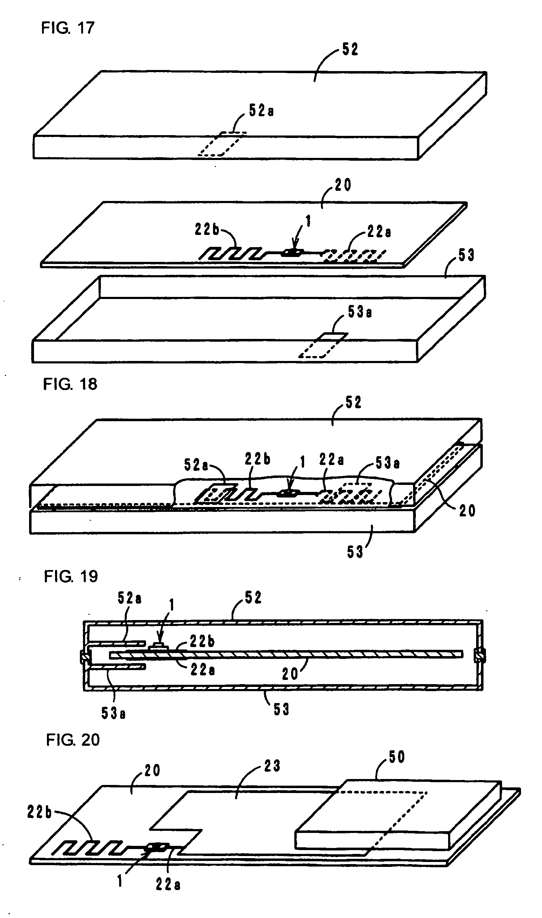

### (Eleventh example, Figs. 17 to 19)

In the radio IC device according to an eleventh example, the printed wiring board 20 is enclosed by an upper and a lower metal case 52 and 53, as shown in Figs. 17 and 18, and the metal cases 52 and 53 function as radiation plates. Wiring electrodes 22a and 22b are formed on the printed wiring board 20 and coupled to the electromagnetic coupling module 1. The wiring electrode 22a is disposed on the rear side and connected to the front side through a via hole conductor. The wiring electrode 22b is disposed on the front side.

As shown in Fig. 19, in addition, the metal case 52 has a coupling conductor 52a to help the metal case 52 couple efficiently to the wiring electrode 22b, and the metal case 53 has a coupling conductor 53a to help the metal case 53 couple efficiently to the wiring electrode 22a.

In the eleventh example as well, the wiring electrodes 22a and 22b function as radiation plates, and the metal cases 52 and 53 coupled to the respective wiring electrodes 22a and 22b also function as the radiation plates. Thus, the radiation characteristics and the antenna gain are enhanced.

### (Twelfth example, Fig. 20)

In the radio IC device according to a twelfth example, part of the metal case 50 is disposed on the ground electrode 23 connected to the wiring electrode 22a as shown in the fifth example (see Fig. 11), as shown in Fig. 20. The ground electrode 23 and the metal case 50 are coupled to each other to function as a radiation plate.

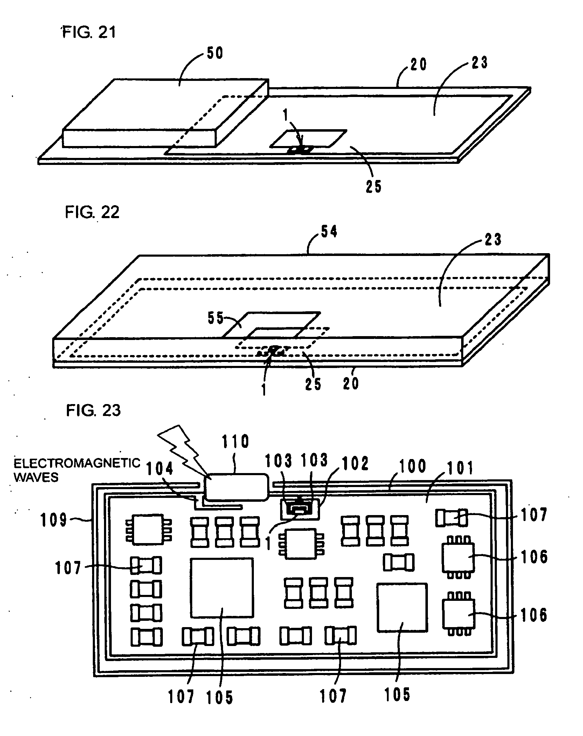

### (13th example, Fig. 21)

In the radio IC device according to a 13th example, the area of the loop electrode 25 provided as the second wiring electrode is increased as shown in Fig. 21 so that the loop electrode 25 can be used as a ground electrode 23 or a power supply electrode. The metal case 50 is disposed on part of the loop electrode 25. In the 13th example, the loop electrode 25 and the metal case 50 function as a radiation plate.

### (Fourteenth example, Fig. 22)

In the radio IC device according to a 14th example, the loop electrode 25 provided as the second wiring electrode and the ground electrode 23 are integrated to function as a radiation plate, and a metal case 54 electrically connected to the ground electrode 23 is disposed on the printed wiring board 20 so as to cover the radiation plate, as shown in Fig. 22. The metal case 54 has a notch 55 in a region corresponding to the loop electrode 25 when viewed from above. Since a magnetic field is generated around the loop electrode 25, the magnetic field is radiated out of the metal case 54 through the notch 55 over the loop electrode 25. Thus, the radiation characteristics are enhanced. The metal case 54 may be disposed so as to cover at least one of other electronic components (not shown).

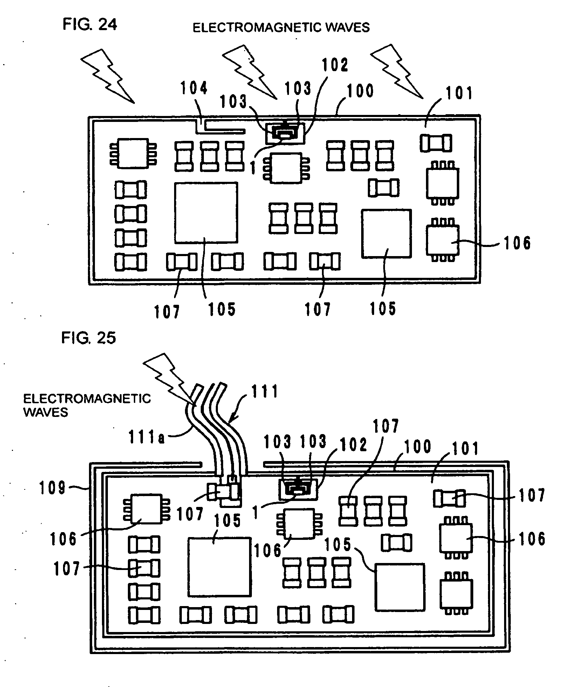

### (15th example, Figs. 23 and 24)

In the radio IC device according to a 15th example, a ground electrode 101 having an opening 102 is disposed on a printed wiring board 100, and a pair of loop electrodes 103 functioning as inductance elements are formed in the opening 102, as shown in Fig. 23. The electromagnetic coupling module 1 (or radio IC chip 5 alone) is coupled to the end of each loop electrode 103. The printed wiring board 100 has switching modules 105, ICs 106, and other elements 107 such as chip resistors and chip capacitors thereon. The printed wiring board 100 is covered with a shielding case 109.

A USB connector 110 is connected to the printed wiring board 100. The metal portion of the connector 110 is electrically continued to the ground electrode 101 and functions as a radiation plate of the electromagnetic coupling module 1. The ground electrode 101 has a slit 104 by the connector 110, so that electromagnetic waves through the connector 110 can efficiently propagate to the loop electrodes 103.

Fig. 24 shows a state before the shielding case 109 and the connector 110 are disposed on the printed wiring board 100. In this state, the ground electrode 101 functions as a radiation plate. Thus, the structure of the 15th example can function as a radio IC device from a stage shown in Fig. 24 to the final stage shown in Fig. 23 of the manufacturing process.

### (16th example, Fig. 25)

In the radio IC device according to a 16th example, the shielding wire 111a of a coaxial cable (power supply cable) 111 is electrically connected to the ground electrode 101 disposed on the printed wiring board 100, as shown in Fig. 25. The other structure is the same as in the 15th example.

In the 16th example, the shielding wire 111a of the coaxial cable 111 electrically connected to the ground electrode 101 functions as a radiation plate of the electromagnetic coupling module 1. Since the shielding wire 111a is long, communication can be performed even with weak electromagnetic waves.

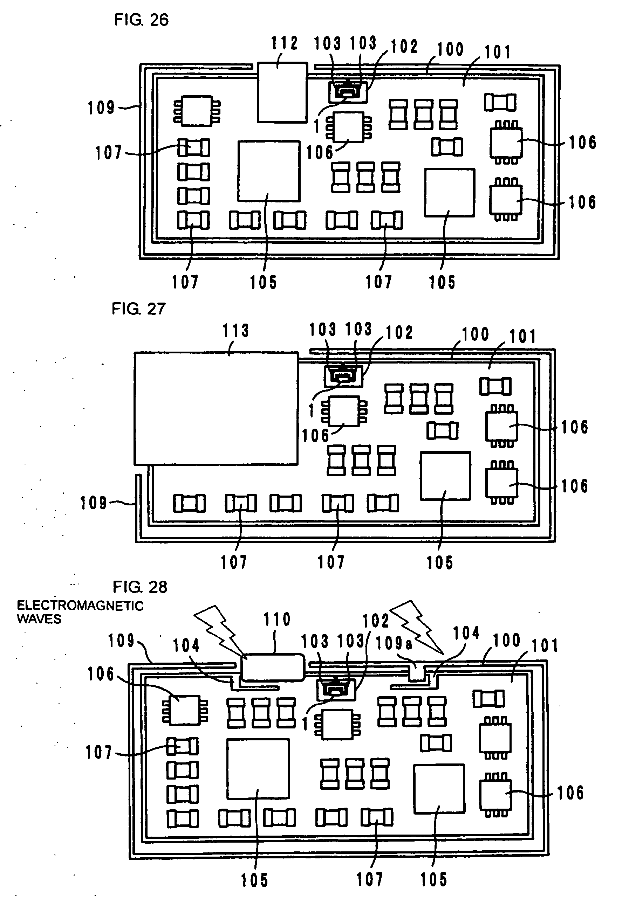

### (17th example, Fig. 26)

In the radio IC device according to a 17th example, a slot case 112 of a USB card is electrically connected to the ground electrode 101 disposed on the printed wiring board 100, as shown in Fig. 26. The other structure is the same as in the 15th example. The slot case 112 is a metal component, and is electrically continued to the ground electrode 101 to function as a radiation plate of the electromagnetic coupling module 1.

### (18th example, Fig. 27)

In the radio IC device according to an 18th example, the metal case of a battery 113 is electrically connected to the ground electrode 101 disposed on the printed wiring board 100, as shown in Fig. 27. The other structure is the same as in the 15th example. The metal case of the battery 113 is electrically continued to the ground electrode 101 to function as the radiation plate of the electromagnetic coupling module 1.

### (Nineteenth example, see Fig. 28)

In the radio IC device according to a 19th example, the shielding case 109 of the 15th example shown in Fig. 23 is electrically connected to the ground electrode 101 through a conductor portion 109a, as shown in Fig. 28. The other structure is the same as in the 15th example. In the 19th example, the shielding case 109 as well as the metal portion of the connector 110 functions as a radiation plate. The ground electrode 101 has a slit 104 by the conductor portion 109a, so that electromagnetic waves through the shielding case 109 can efficiently propagate to the loop electrode 103.

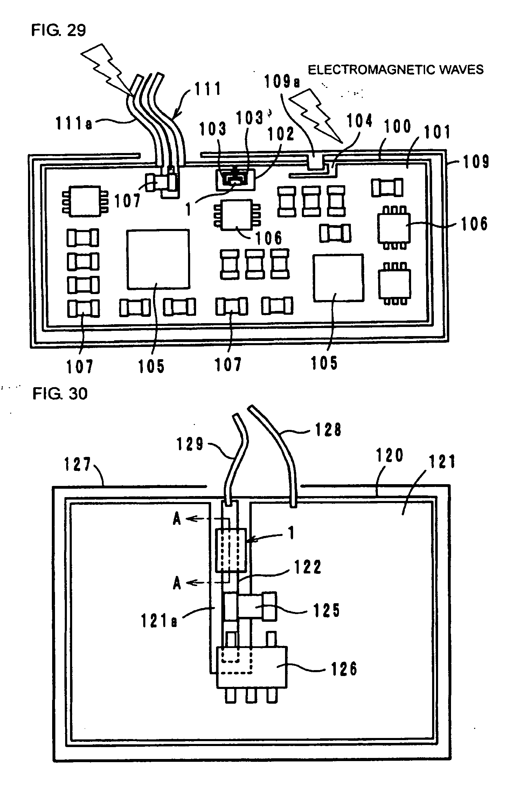

### (20th example, Fig. 29)

In the radio IC device according to a 20th example, the shielding case 109 of the 16th example shown in Fig. 25 is electrically connected to the ground electrode 101 through a conductor portion 109a, as shown in Fig. 29. The other structure is the same as in the 16th example. In the 20th example, the shielding case 109 as well as the shielding wire 111a of the coaxial cable 111 functions as a radiation plate. The ground electrode 101 has a slit 104 by the conductor portion 109a, so that electromagnetic waves through the shielding case 109 can efficiently propagate to the loop electrode 103.

### (21st example, Figs. 30 to 32)

In the radio IC device according to a 21st example, a ground electrode 121 disposed on a printed wiring board 120 has a slit opening 121a, as shown in Fig. 30. A wiring electrode (hereinafter referred to as power line 122) is provided in the slit opening 121a. A power supply cable 128 is connected to the ground electrode 121, and another power supply cable 129 is connected to the power line 122. In this state, the electromagnetic coupling module 1 is bonded on the power line 122. The printed wiring board 120 is covered with a shielding case 127 and the power supply cables 128 and 129 extend long out of the shielding case 127. The power line 122 is provided with a capacitor 125 for rejecting high-frequency noises, a voltage regulator 126 and the like to stabilize the voltage.

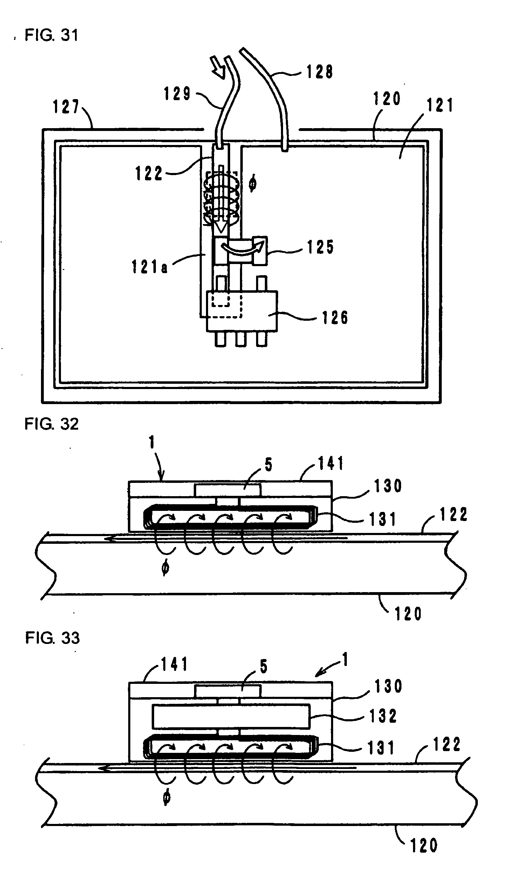

The electromagnetic coupling module 1 includes a feed circuit board 130 containing a coil (inductance element) 131, a radio IC chip 5 on the feed circuit board 130, and a resin protecting member 141 covering the feed circuit board 130 and the radio IC chip 5, as shown in Fig. 32. The coil 131 is disposed in such a manner that the coil axis extends parallel to the power line 122, and each end of which is electrically connected to the radio IC chip 5.

In the operation principle of the radio IC device of the 21st example, when the power supply cable 129 receives magnetic waves from a reader/writer (not shown), the power line 122 generates a current, as shown in Fig. 31. The current flows to the ground electrode 121 through the capacitor 125 to generate a magnetic field φ at the power line 122. The magnetic field φ is coupled to the coil 131 of the feed circuit board 130, thus operating the radio IC chip 5.

In the 21st example, the power supply cable 129 functions as a radiation plate. Also, the power line 122 functions as a radiation plate in the course of the manufacturing process in which the shielding case 127 or the power supply cable 129 is not provided. The power supply cable 129 may be directly connected to the reader/writer.

### (22nd example, see Fig. 33)

In the radio IC device according to a 22nd example, the feed circuit board 130 of the electromagnetic coupling module 1 is provided with a matching circuit/resonance circuit 132 in addition to the coil 131, as shown in Fig. 33. The other structure is the same as in the 21st example. The 22nd example produces the same effects as the 21st example. In particular, when the circuit 132 is a matching circuit, the matching with the coil 131 can be made, so that the radio IC chip 5 can be operated even at a low power. When the circuit 132 is a resonance circuit, the radio IC chip can be frequency-selective, and accordingly the variation in frequency can be reduced. Thus, the radio IC chip can work in a wide range of frequencies.

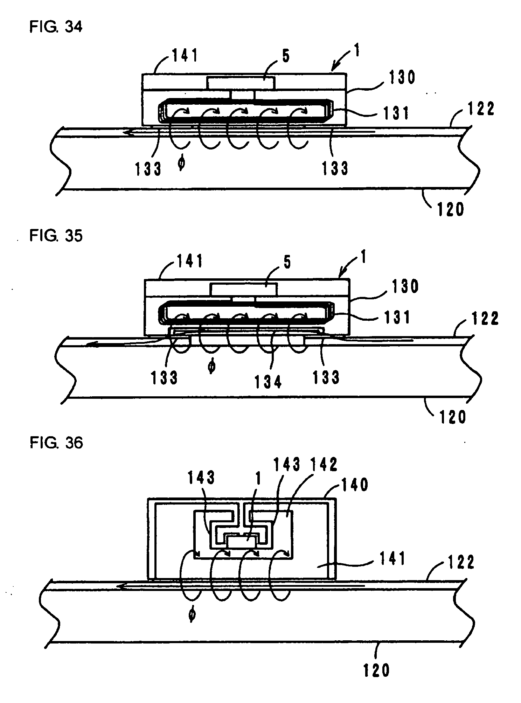

### (23rd example, Fig. 34)

In the radio IC device according to a 23rd example, the feed circuit board 130 of the electromagnetic coupling module 1 is provided with a pair of external terminal electrodes 133 on the rear surface thereof, as shown in Fig. 34. The other structure is the same as in the 21st example. The 23rd example produces the same effects as the 21st example. In particular, the external terminal electrodes 133 formed on the rear surface of the feed circuit board 130 allow the electromagnetic coupling module 1 to be joined to the power line 122 with solder; hence, the electromagnetic coupling module 1 can be mounted simultaneously with other surface mount components. Alternatively, only a single external terminal electrode 133 may be formed at substantially the center of the rear surface of the feed circuit board 130.

### (24th example, Fig. 35)

In the radio IC device according to a 24th example, the feed circuit board 130 of the electromagnetic coupling module 1 is provided with a pair of external terminal electrodes 133 on the rear surface thereof, as shown in Fig. 35. In addition, a conductor 134 is disposed within the feed circuit board 130 on the rear surface side, and the power line 122 is cut under the conductor 134. The other structure is the same as in the 21st and the 23rd example. The 24th example produces the same effects as the 21st and the 23rd example. Since the current running in the power line 122 is conducted to flow near the coil 131 by the conductor 134, the degree of coupling is enhanced, and accordingly the radio IC chip can operate at a low power. In addition, the variation in coupling degree is reduced.

### (25th example, Fig. 36)

In the radio IC device according to a 25th example, an auxiliary substrate 140 is provided on which an electromagnetic coupling module 1 is mounted, as shown in Fig. 36. A coupling electrode 141 having an opening 142 is formed on the auxiliary substrate 140, and a pair of loop electrodes 143 functioning as inductance elements is formed in the opening 142. The electromagnetic coupling module 1 (or radio IC chip 5 alone) is coupled to the end of each loop electrode 143. The other structure is the same as in the 21st example.

In the 25th example, the electromagnetic coupling module 1 is coupled to the loop electrodes 143, and in addition, the coupling electrode 141 is coupled to the power line 122. The same effects are produced as in the 21st example. In particular, the use of the auxiliary substrate 140 allows the use of a large coupling electrode 141 or the increase of the coil 131 in the feed circuit board 130. Thus, the degree of coupling to the power line 122 can be increased. In addition, the coupling electrode 141 on the auxiliary substrate 140 can function as the radiation plate by itself, and can be disposed anywhere on the printed wiring board 120.

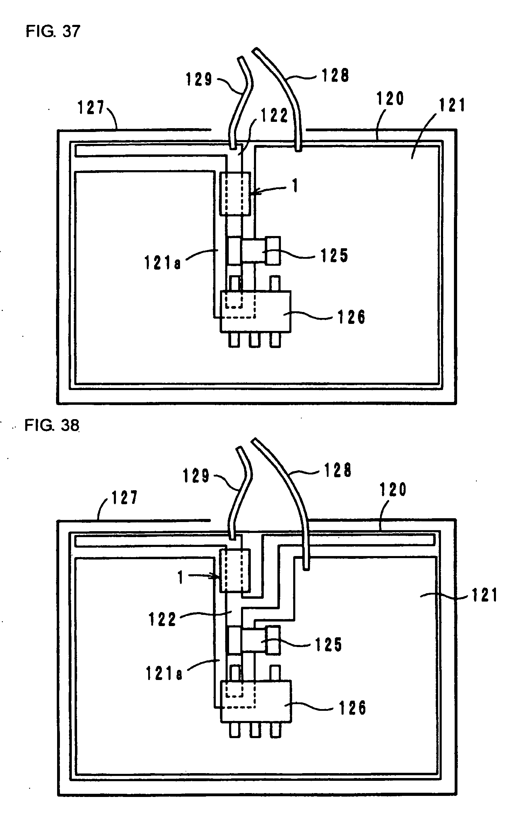

### (26th example, Fig. 37)

In the radio IC device according to a 26th example, a power line 122 on which the electromagnetic coupling module 1 is mounted is formed so as to extend long in the lateral direction along an edge of the printed wiring board 120, as shown in Fig. 37. The other structure is the same as in the 21st example (see Fig. 30). The 26th example produces the same effects as the 21st example. The lengthened power line 122 can more function as the radiation plate and allows the radio IC device to function before the shielding case 127 or the power supply cable 129 is provided.

### (27th example, Fig. 38)

In the radio IC device according to a 27th example, the power line 122 shown in Fig. 37 is branched so as to extend long in the lateral direction along an edge of the printed wiring board 120, as shown in Fig. 38. The other structure is the same as in the 21st and the 26th example. Since the power line 122 functioning as a radiation plate of the 27th example is longer than that of the 26th example, electromagnetic waves can be more efficiently transmitted and received, and the operation can be performed at a low power. Preferably, the power line 122 has such a length as can resonate.

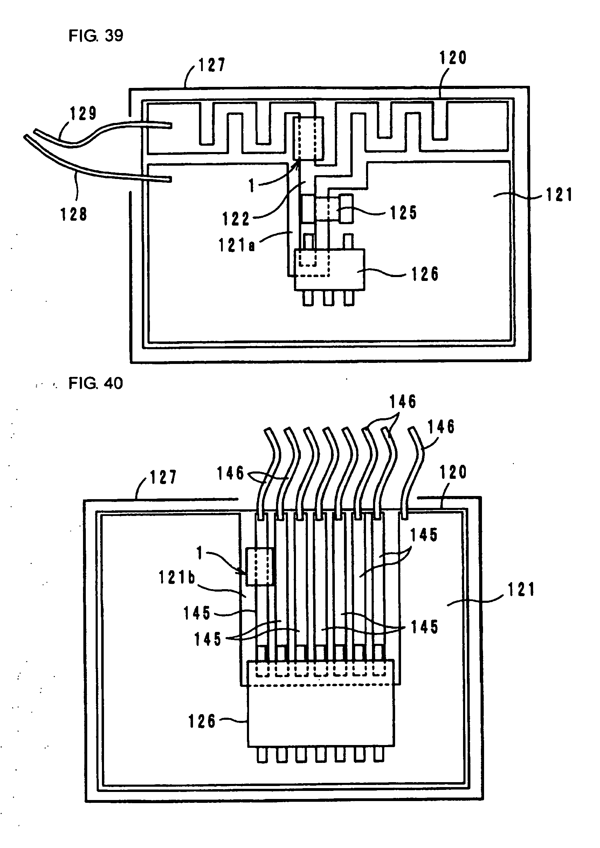

### (28th example, Fig. 39)

In the radio IC device according to a 28th example, the extensions of the power line 122 shown in Fig. 38 are formed in a meandering manner, as shown in Fig. 39. The other structure is the same as in the 21st example. In the 28th example, the power line 122 functioning as a radiation plate is substantially large, and accordingly electromagnetic waves can be transmitted and received more efficiently.

### (29th example, Fig. 40)

In the radio IC device according to a 29th example, the ground electrode 121 disposed on the printed wiring board 120 has a relatively large opening 121b in which a plurality of line electrodes 145 are formed in parallel with each other. The line electrodes 145 are connected to signal lines 146, such as for a USB, and one of which is coupled to the electromagnetic coupling module 1, as shown in Fig. 40. A regulator 126 is disposed between the line electrodes 145 and the ground electrode 121.

In the 29th example, the signal lines 146 functions as a radiation plate, and the same effects are produced as in the 21st example and other examples. In particular, the radio IC device can function even though it is driven by a battery and does not have a power supply cable.

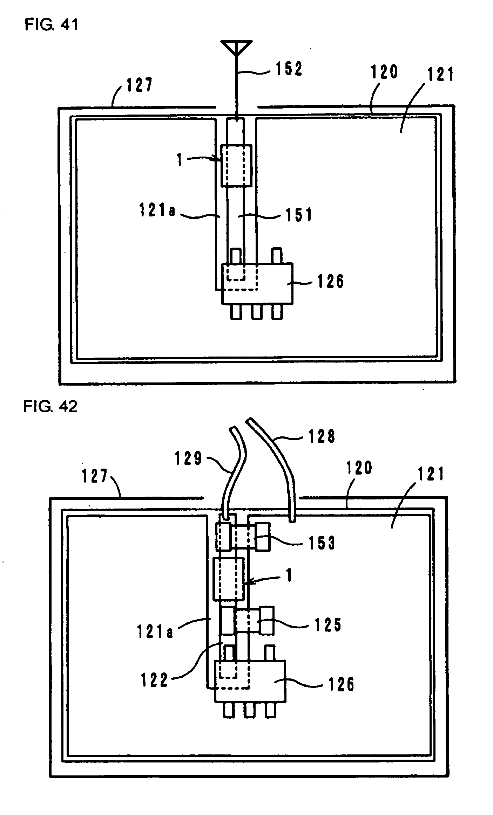

### (30th example, Fig. 41)

In the radio IC device according to a 30th example, the electrode 121 disposed on the printed wiring board 120 has a slit opening 121a, as shown in Fig. 41. An antenna line 151 is disposed in the slit opening 121a, and an antenna wire 152 is connected to the antenna line 151. The electromagnetic coupling module 1 is coupled to the antenna line 151. The regulator 126 is disposed between the antenna line 151 and the ground electrode 121.

In the 30th example, the antenna wire 152 functions as a radiation plate, and the same effects are produced as in the 21st example and other examples. The electromagnetic coupling module 1 is provided with a resonance circuit or a matching circuit so that energy is transmitted to the radio IC chip 5 only at a frequency at which the IC chip 5 operates as an RFID, thus preventing the interference with the operation of the antenna. In the present example, the antenna wire 152 intended to receive electromagnetic waves efficiently is used as a radiation plate. Accordingly, the operation can be performed at a low power.

### (31st example, Fig. 42)

In the radio IC device according to a 31st example, an anti-ESD device, such as a varistor 153, is disposed between the power line 122 and the ground electrode 121, and the electromagnetic coupling module 1 is disposed downstream from the varistor 153, as shown in Fig. 42. The other structure is the same as in the 21st example (see Fig. 30). The 31st example produces the same effects as the 21st example. In particular, the presence of the varistor 153 enhances the electrostatic surge resistance.

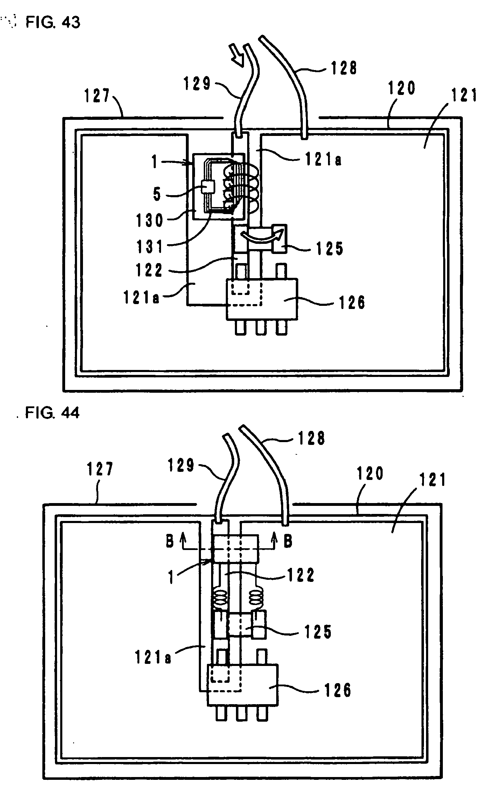

### (32nd example, Fig. 43)

The radio IC device according to a 32nd example is the same as that of the 21st example (see Fig. 30) in that the electromagnetic coupling module 1 is coupled to the power line 122, as shown in Fig. 43. The two example have a difference in that the coil 131 provided on the feed circuit board 130 is disposed in such a manner that the coil axis extends in the direction perpendicular to the power line 122. The 32nd example produces the same effects as the 21st example. In particular, the coil 131 is formed in such a manner that the coil axis extends in the direction in which the sheets of the feed circuit board 130 are stacked, and this facilitates the formation of the coil 131.

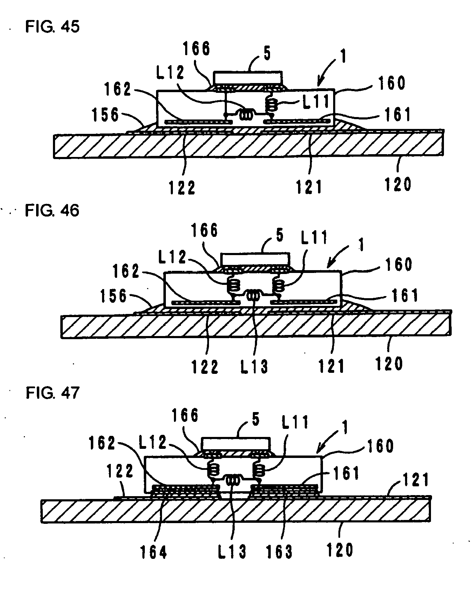

### (33rd example, Figs. 44 and 45)

In the radio IC device according to a 33rd example, the ground electrode 121 disposed on the printed wiring board 120 has a slit opening 121a, as shown in Fig. 44. A power line 122 is disposed in the slit opening 121a. A power supply cable 128 is connected to the ground electrode 121, and another power supply cable 129 is connected to the power line 122. In this state, an electromagnetic coupling module 1 is bonded across the region between the power line 122 and the ground electrode 121. The printed wiring board 120 is covered with a shielding case 127 and the power supply cables 128 and 129 extend long out of the shielding case 127. The power line 122 is provided with a capacitor 125 for rejecting high-frequency noises, a voltage regulator 126 and the like to stabilize the voltage.

The electromagnetic coupling module 1 includes the radio IC chip 5 and a feed circuit board 160, as shown in Fig. 45. The feed circuit board 160 contains inductance elements L11 and L12 magnetically coupled to each other, and a resonance circuit having a predetermined resonance frequency with capacitors defined by an internal electrode 161 and a ground electrode 121 and by an internal electrode 162 and a power line 122. The radio IC chip 5 is electrically connected to the resonance circuit with solder bumps. In Fig. 45, reference numeral 156 designates an adhesive, and reference numeral 166 designates a protective layer for the solder bumps.

In the operation principle of the radio IC device of the 33rd example, when the power supply cable 129 receives magnetic waves from a reader/writer (not shown), the power line 122 generates a current. In this instance, the power line 122 and the ground electrode 121 have a potential difference therebetween, because of the presence of an inductance component (in a coil form) as shown in Fig. 44 in view of high frequency. The occurrence of the potential difference allows the internal electrodes 161 and 162 of the feed circuit board 160 to be electromagnetically coupled to the ground electrode 121 and the power line 122, so that a signal operates the radio IC chip 5 through the resonance circuit.

In the 33rd example as well, the power supply cable 129 functions as a radiation plate, and basically the same effects are produced as in the 21st example (see Fig. 30). Since the feed circuit board 160 contains the resonance circuit including the inductance elements L11 and L12 and the capacitor, the feed circuit board has a function for matching with the radio IC chip 5 and a function for selecting frequency. Thus, signals can be transmitted in a wide range of frequencies. The electromagnetic coupling module 1 may be replaced with only a radio IC chip 5.

### (34th example, Fig. 46)

In the radio IC device according to 34th example, the resonance circuit provided in the feed circuit board 160 of the electromagnetic coupling module 1 is defined by inductance elements L11, L12 and L13 coupled to each other, as shown in Fig. 46. In the 34th example, the other structure is the same as in the 33rd example, and the same effects are produced as in the 33rd example. In particular, since the resonance circuit is bilaterally symmetrical, the electromagnetic coupling module 1 can be mounted without considering the directivity.

### (35th example, Fig. 47)

In the radio IC device according to a 35th example, external terminal electrodes 163 and 164 opposing the internal electrodes 161 and 162 are formed on the rear surface of the feed circuit board 160, as shown in Fig. 47. In the 35th example, the other structure is the same as in the 34th example, and the same effects are produced as in the 34th example. By providing the external terminal electrodes 163 and 164, the electromagnetic coupling module 1 can be bonded on the printed wiring board 120 with solder, and thus can be mounted simultaneously with other surface mount components.

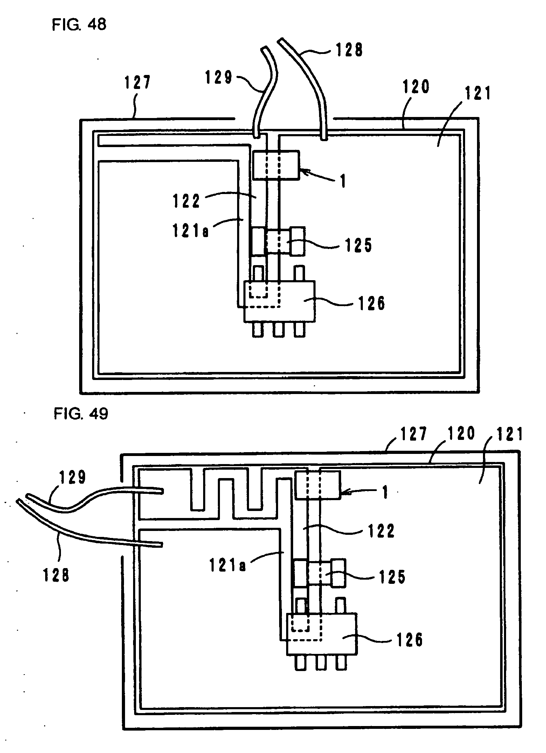

### (36th example, Fig. 48)

In the radio IC device according to a 36th example, a power line 122 on which the electromagnetic coupling module 1 is mounted is formed so as to extend long in the lateral direction along an edge of the printed wiring board 120, as shown in Fig. 48. The other structure is the same as in the 33rd example (see Fig. 44). The 36th example produces the same effects as the 33rd example. The lengthened power line 122 can more function as the radiation plate and allows the radio IC device to function before the shielding case 127 or the power supply cable 129 is provided.

### (37th example, Fig. 49)

The radio IC device according to a 37th example, the extension of the power line 122 shown in Fig. 48 is formed in a meandering manner, as shown in Fig. 49. The other structure is the same as in the 33rd example. In the 37th example, the power line 122 functioning as a radiation plate is substantially large, and accordingly electromagnetic waves can be transmitted and received more efficiently.

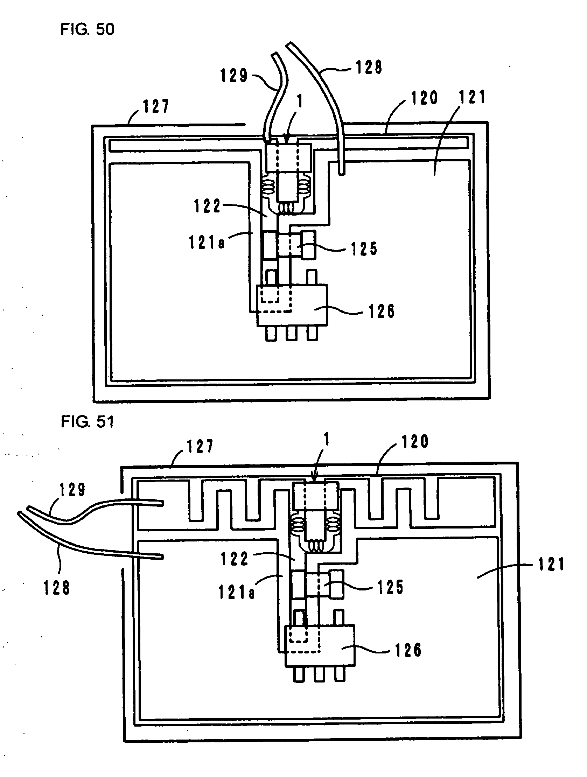

### (38th example, Fig. 50)

In the radio IC device according to a 38th example, the power line 122 shown in Fig. 48 is branched so as to extend long in the lateral direction along an edge of the printed wiring board 120, as shown in Fig. 50. The other structure is the same as in the 33rd and the 36th example. Since the power line 122 functioning as a radiation plate of the 38th example is longer than that of the 36th example, electromagnetic waves can be more efficiently transmitted and received, and the operation can be performed at a low power. Preferably, the power line 122 has such a length as can resonate.

### (39th example, Fig. 51)

In the radio IC device according to a 39th example, the extensions to both sides of the power line 122 are formed in a meandering manner, as shown in Fig. 51. The other structure is the same as in the 33rd example. In the 39th example, the power line 122 functioning as a radiation plate is substantially large, and accordingly electromagnetic waves can be transmitted and received more efficiently.

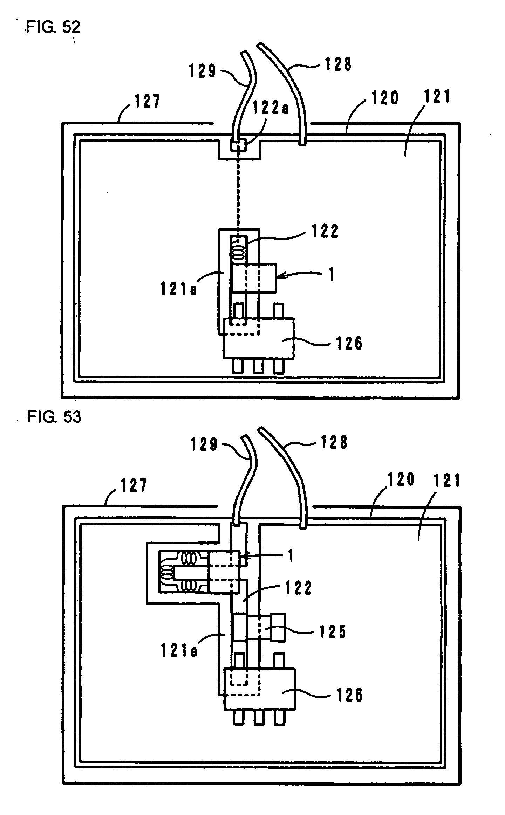

### (40th example, see Fig. 52)

In the radio IC device according to a 40th example, part of the power line 122 is formed under the printed wiring board 120, as shown in Fig. 52, and the electromagnetic coupling module 1 is mounted across the region between the power line 122 exposed at the surface and the ground electrode 121. The power supply cable 129 is connected to an end 122a of the power line exposed at the surface.

In the 40th example, the other structure is the same as in the 33rd example, and the same effects are produced as in the 33rd example. In particular, since the power line 122 is partially disposed under the printed wiring board 120, the flexibility of wiring on the surface is enhanced.

### (41st example, Fig. 53)

In the radio IC device according to a 41st example, the power line 122 is bent in a C shape and both ends of the electromagnetic coupling module 1 are connected to the bent portions, as shown in Fig. 53. In the 41st example, the other structure is the same as in the 33rd example, and the same effects are produced as in the 33rd example.

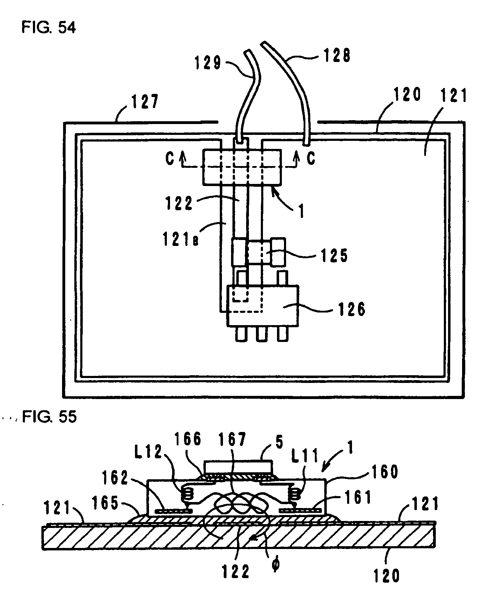

### (42nd example, Figs. 54 and 55)

In the radio IC device according to a 42nd example, the electromagnetic coupling module 1 is mounted across the power line 122 from one end of the ground electrode 121 to the opposing end, as shown in Fig. 54. The other structure is the same as in the 33rd example, and the electromagnetic coupling module 1 is operated by a difference in potential produced on the ground electrode 121.

In the 42nd example, the feed circuit board 160 contains a coil 167 coupled by a magnetic field φ generated by the current flowing in the power line 122 in addition to the inductance elements L11 and L12, as shown in Fig. 55. The coil 167 is connected in series with the inductance elements L11 and L12, and is thus operated by the current flowing in the power line 122. In other words, the coil 167 functions as a matching inductance element. Even if the power line cannot sufficiently receive magnetic waves, the ground electrode 121 can function as a radiation palate, and even if either element of the feed circuit is broken, the other element ensures the operation.

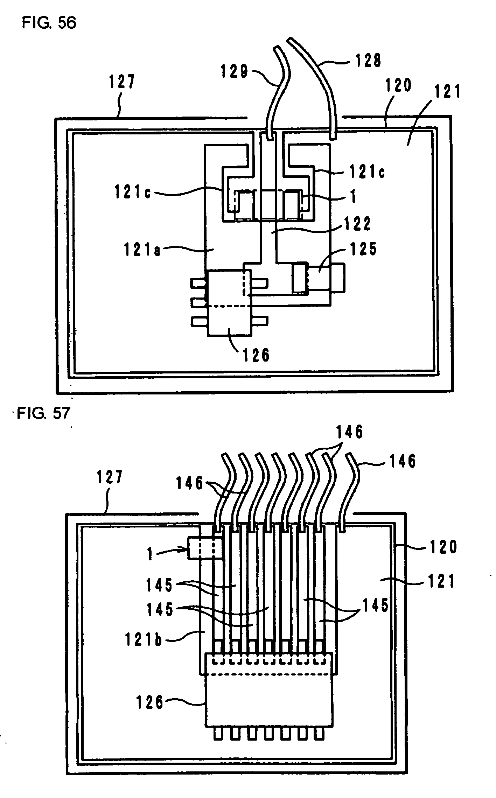

### (43rd example, Fig. 56)

In the radio IC device according to a 43rd example, part 121c of the ground electrode 121 coupled to the feed circuit of the electromagnetic coupling module 1 is formed in a loop, as shown in Fig. 56. The other structure is the same as in the 33rd and the 42nd example, and the same effects are produced as in the 33rd and the 42nd examples. By forming the part 121c of the ground electrode 121 coupled to the resonance circuit in a loop, the antenna gain is enhanced, and the radio IC chip 5 can be operated at a low power.

### (44th example, Fig. 57)

In the radio IC device according to a 44th example, the ground electrode 121 disposed on the printed wiring board 120 has a relatively large opening 121b in which a plurality of line electrodes 145 are formed in parallel with each other. The line electrodes 145 are connected to signal lines 146, such as for a USB, and the electromagnetic coupling module 1 is disposed across the region between the ground electrode 121 and one of the line electrodes 145 to be coupled to that one line electrode, as shown in Fig. 57. A regulator 126 is disposed between the line electrodes 145 and the ground electrode 121.

In the 44th example, the signal lines 146 function as a radiation plate using the difference in potential between the line electrode 145 and the ground electrode 121, and the same effects are produced as in the 33rd and the 29th example.

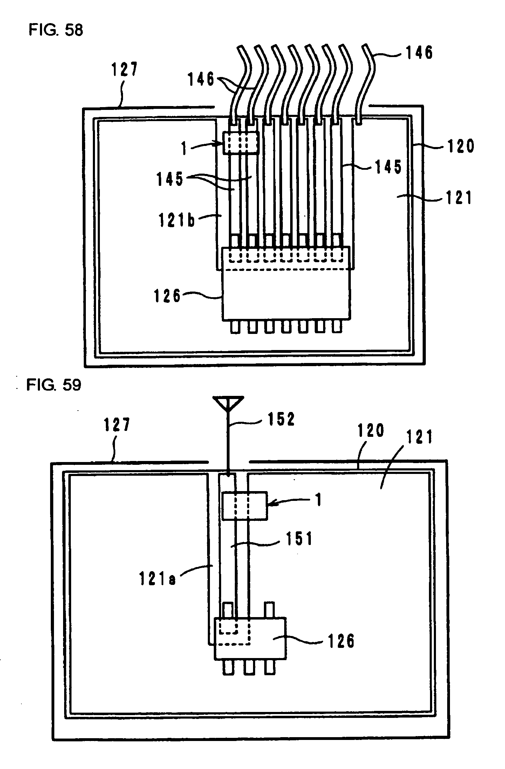

### (45th example, Fig. 58)

In the radio IC device according to a 45th example, the electromagnetic coupling module 1 is coupled so as to be disposed across the region between two adjacent line electrodes 145, as shown in Fig. 58. The other structure is the same as in the 44th example and the same effects are produced as in the 44th example. The 45th example uses the difference in potential between the two adjacent line electrodes 145.

### (46th example, Fig. 59)

In the radio IC device according to a 46th example, the ground electrode 121 disposed on the printed wiring board 120 has a slit opening 121a, as shown in Fig. 59. An antenna line 151 is disposed in the slit opening 121a, and an antenna wire 152 is connected to the antenna line 151. The electromagnetic coupling module 1 is coupled so as to be disposed across a region between the antenna line 151 and the ground electrode 121. The regulator 126 is disposed between the antenna line 151 and the ground electrode 121. In the 46th example, the antenna wire 152 functions as the radiation plate, and the same effects are produced as in the 33rd and the 30th example.

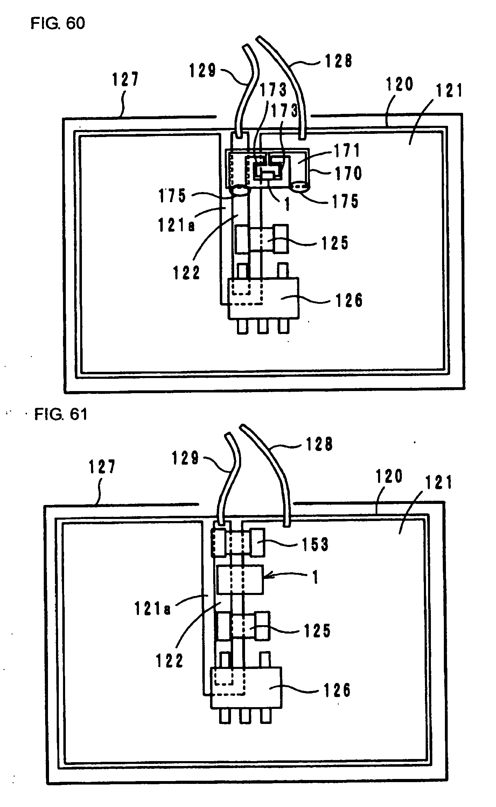

### (47th example, Fig. 60)

In the radio IC device according to a 47th example, an auxiliary substrate 170 is provided on which the electromagnetic coupling module 1 is mounted, as shown in Fig. 60. A coupling electrode 171 is formed on the auxiliary substrate 170, and a pair of loop electrodes 173 functioning as inductance elements is formed to the coupling electrode 171. The electromagnetic coupling module 1 (or radio IC chip 5 alone) is coupled to each end of the loop electrodes 173. The ends of the coupling electrode 171 are connected to the power line 122 and the ground electrode 121 with solder 175. The other structure is the same as in the 33rd example.

In the 47th example, the electromagnetic coupling module 1 is coupled to the loop electrodes 173, and in addition, the coupling electrode 171 is disposed across the region between the power line 122 and the ground electrode 121 so as to be coupled to the power line 122 and the ground electrode 121. Thus, the same effects are produced as in the 33rd example. In particular, the use of the auxiliary substrate 170 allows even a small electromagnetic coupling module 1 to be disposed across the region between the power line 122 and the ground electrode 121. In addition, an inductance element or the like may be formed on the auxiliary substrate 170 to reduce the size of the feed circuit board 160. Furthermore, the coupling electrode 171 on the auxiliary substrate 170 functions as a radiation plate by itself.

### (48th example, Fig. 61)

In the radio IC device according to a 48th example, an anti-ESD device, such as a varistor 153, is disposed between the power line 122 and the ground electrode 121, and an electromagnetic coupling module 1 is disposed downstream from the varistor 153, as shown in Fig. 61. The other structure is the same as in the 33rd example (see Fig. 44). The 48th example produces the same effects as the 33rd and the 31st example.

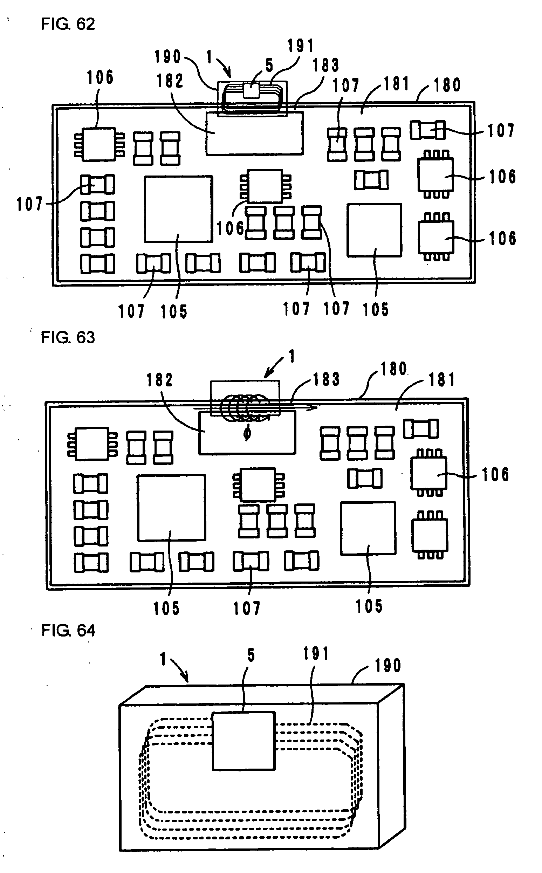

### (49th example, Figs. 62 to 65)

In the radio IC device according to a 49th example, a ground electrode 181 disposed on a printed wiring board 180 has an opening 182 to define a loop electrode 183, and the electromagnetic coupling module 1 is mounted on the loop electrode 183, as shown in Fig. 62. The electromagnetic coupling module 1 includes the radio IC chip 5 and a feed circuit board 190. The feed circuit board 190 contains a coil (inductance element) 191, as shown in Fig. 64. The coil 191 is disposed in such a manner that the coil axis extends parallel to the loop electrode 183, and each end of the coil 191 is electrically connected to the radio IC chip 5.

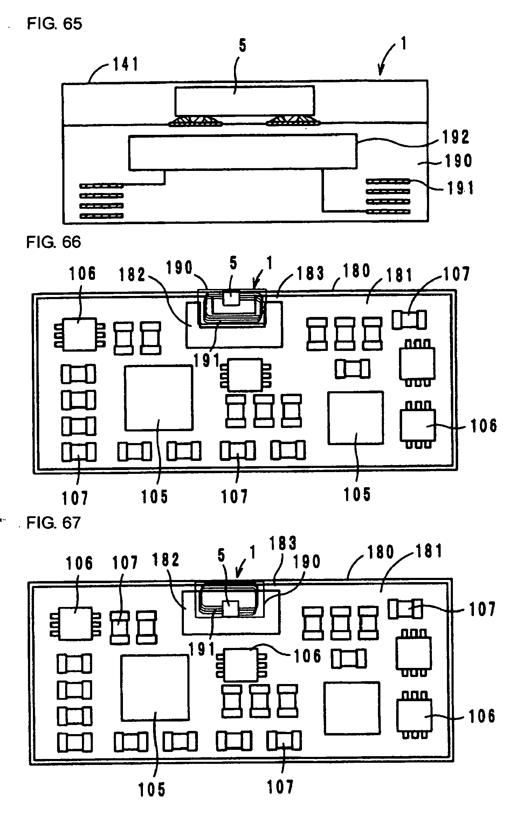

In the operation principle of the radio IC device of the 49th example, when the ground electrode 181 receives magnetic waves from a reader/writer (not shown), the loop electrode 183 generates a current. The magnetic field φ generated by the current is coupled to the coil 191 of the feed circuit board 190, thus operating the radio IC chip 5. In this instance, preferably, the electromagnetic coupling module 1 is disposed in such a manner that a magnetic field φ intersects only one side of the coil 191. In addition to the coil 191, a matching circuit/resonance circuit 192 may be provided within the feed circuit board 190, as shown on Fig. 65.

The elements 105, 106 and 107 disposed on the printed wiring board 180 are the same as in the 15th example (see Fig. 23).

### (50th example, Fig. 66)

In the radio IC device according to a 50th example, the loop electrode 183 formed on the ground electrode 181 is bent in a C shape, and the electromagnetic coupling module 1 is mounted in such a manner that the coil 191 is disposed along the loop electrode 183, as shown in Fig. 66. The other structure is the same as in the 49th example.

The 50th example produces the same effects as the 49th example. In particular, the degree of coupling between the coil 191 and the loop electrode 183 is enhanced and the energy can be efficiently transmitted. In addition, the electromagnetic coupling module 1 hardly protrudes from the edge of the printed wiring board 180.

### (51st example, Fig. 67)

In the radio IC device according to a 51st example, the electromagnetic coupling module 1 is disposed in a reverse orientation to that in the 49th example (see Fig. 62) on the printed wiring board 180, as shown in Fig. 67. The other structure is the same as in the 49th example, and the same effects are produced as in the 49th example. In particular, it is an advantage that the electromagnetic coupling module 1 hardly protrudes from the edge of the printed wiring board 180.

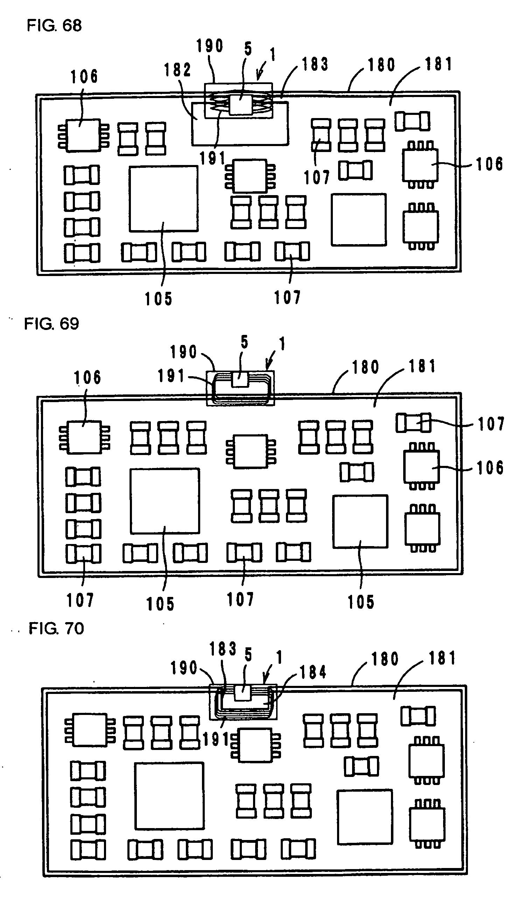

### (52nd example, Fig. 68)

In the radio IC device according to a 52nd example, the feed circuit board 190 contains a coil 191 in such a manner that the coil axis extends perpendicular to the loop electrode 183, as shown in Fig. 68. The 52nd example produces the same effects as the 49th example. In particular, the coil 191 is formed in such a manner that the coil axis extends in the direction in which the sheets of the feed circuit board 190 are stacked, and this facilitates the formation of the coil 191.

### (53rd example, Fig. 69)

In the radio IC device according to a 53rd example, the electromagnetic coupling module 1 is mounted at an edge of the ground electrode 181 without forming a loop electrode 183 on the ground electrode 181, as shown in Fig. 69. The other structure is the same as in the 49th example, and the same effects are produced as in the 49th example. The electromagnetic coupling module 1 is operated by being coupled with a magnetic field generated by the current flowing in the edge of the ground electrode 181.

### (54th example, Fig. 70)

In the radio IC device according to a 54th example, a notch 184 is formed in the printed wiring board 180, and the ground electrode 181 has a loop electrode 183 at the edge around the notch 184, as shown in Fig. 70. The other structure is the same as in the 49th example, and the same effects are produced as in the 49th example.

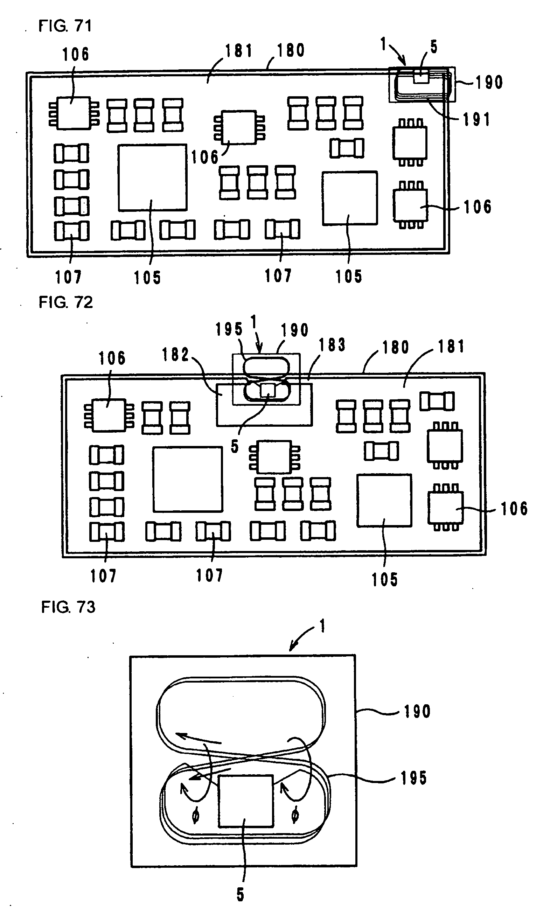

### (55th example, Fig. 71)

In the radio IC device according to a 55th example, the electromagnetic coupling module 1 is disposed in a corner of the ground electrode 181 as shown in Fig. 71, unlike the 53rd example in which the electromagnetic coupling module 1 is disposed substantially at the center of an edge of the ground electrode 181. The other structure is the same as in the 49th and the 53rd example, and the same effects are produced as in the 49th and 53rd example.

If the ground electrode 181 does not have the loop electrode 183, the electromagnetic coupling module 1 can be disposed anywhere on the edge of the ground electrode 181. Alternatively, a notch may be formed in the corner of the printed wiring board 180 on which the electromagnetic coupling module 1 is disposed, as disclosed in the 54th example, and the ground electrode 181 has a loop electrode at the edge around the notch.

### (56th example, Figs. 72 and 73)

In the radio IC device according to a 56th example, a coil 195 in a feed circuit board 190 forms a figure of 8, as shown in Fig. 72, and the other structure is the same as in the 49th example (see Fig. 62). The electromagnetic coupling module 1 is disposed on the printed wiring board 180 in such a manner that the magnetic flux φ generated from the loop electrode 183 can pass through the loops of the coil 195 functioning as inductance elements, as shown in Fig. 73. In the 56th example, consequently, the ground electrode 181 functioning as a radiation plate and the electromagnetic coupling module 1 can be highly coupled.

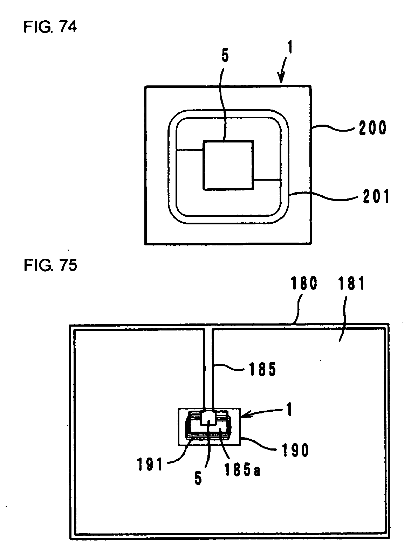

### (Modification of electromagnetic coupling module, Fig. 74)

The electromagnetic coupling module 1 may include a square feed circuit board 200, as shown in Fig. 74. The coil 201 functioning as an inductance element also has a square shape. This electromagnetic coupling module 1 can be applied to any embodiment or example.

### (Embodiment, Fig. 75)

In the radio IC device according to an embodiment, a slit 185 is formed in the ground electrode 181 disposed on the printed wiring board 180, extending from the edge to the center. The slit 185 has an opening 185a at the end thereof, and the electromagnetic coupling module 1 is disposed over the opening 185a, as shown in Fig. 75. The coil 191 formed on the feed circuit board 190 and the opening 185a have substantially the same shape in plan view.

In the embodiment, the surrounding of the opening 185a functions as a loop electrode to be magnetically coupled to the coil 191. The presence of the slit 185 helps the concentration of the current produced by the electromagnetic waves received by the ground electrode 181 around the opening 185a to generate a strong magnetic field, thus enhancing the degree of coupling.

The slit 185 does not necessarily communicate with the edge of the ground electrode 181. If the slit 185 is to be formed according to the design of the printed wiring board 180, another slit is not necessarily formed for the electromagnetic coupling module 1.

### (Conclusion)

In the radio IC device the feed circuit board may have a resonance circuit through which the radio IC is operated by the signal received by the radiation plate, and through which the answer signal from the radio IC is radiated from the radiation plate to the outside. The feed circuit board may include a matching circuit.

The inductance element may be defined by a spiral electrode, and the spiral electrode may be coupled with a magnetic field generated at the wiring electrode on the wiring board. The wiring electrode and the ground electrode on the wiring board may be isolated from each other, and the feed circuit board may be disposed across a region between the wiring electrode and the ground electrode. If the case is a metal, the case can function as a radiation plate by itself. If the case is nonconductive, an electroconductive electrode film may be formed on the case and the electrode film is used as the radiation plate.

The printed wiring board may include an electromagnetic coupling module and other electronic components, and a case doubling as the radiation plate is disposed so as to cover the high frequency device and other electronic components. The printed wiring board may include a second wiring electrode for coupling the feed circuit and the radiation plate. In particular, if the second wiring electrode is in a loop, the impedances can be matched between the radio IC and the radiation plate without providing an additional matching portion, and the signal transmission efficiency can be enhanced between the radio IC and the radiation plate. The loop electrode may be formed in an auxiliary substrate disposed on the feed circuit board. A plurality of printed wiring boards may be used, and a high frequency device is disposed on at least one of the printed wiring boards. A case may be disposed so as to cover the high frequency device and at least one of other electronic components.

The printed wiring board may include a second wiring electrode for coupling the feed circuit and the radiation plate, and a case may be disposed so as to cover all the electronic components and high frequency device mounted on the printed wiring board. The second wiring electrode may serve as part of the radiation plate. In this instance, the radiation characteristics can be enhanced, and the directivity can be changed depending on the arrangement of the second wiring electrode. At least part of the electronic components may serve as part of a radiation plate to enhance the radiation characteristics.

The printed wiring board may include a ground electrode, and a second wiring electrode is electrically connected to the ground electrode. By using the ground electrode having a large area as a radiation plate, the radiation characteristics can further be enhanced.

The second wiring electrode may be formed on the surface of or within the printed wiring board. The printed wiring board may be made of a resin or a ceramic.

An external electrode coupled to the feed circuit may be formed on the surface of the feed circuit board.

The feed circuit board may be made of a ceramic or liquid crystal polymer multilayer substrate, or a flexible substrate. The use of a multilayer substrate allows an inductance element or a capacitance element to be disposed precisely within the feed circuit board, thus enhancing the flexibility in forming electrodes. The use of a flexible substrate facilitates the reduction of the thickness or profile of the feed circuit board.

The radio IC may be rewritable as well as storing information of the commodity on which the radio IC device is attached, and may have other functions in addition to the function for an RFID system.

For example, various types of resonance circuit or matching circuit may be used. The materials used for the external electrode and the feed circuit board are described as examples, and any material can be used as long as it has desired properties. The radio IC chip can be mounted on the feed circuit board by any method other than using a metal bump. The radio IC chip and the feed circuit may be connected by electromagnetic coupling instead of electrical direct connection. The feed circuit board may include a radio IC.

The electromagnetic coupling module may be used in a variety of apparatuses including household electrical appliances, such as TV set and refrigerator, without limiting to radio communication apparatuses, such as cellular phone.

### Industrial Applicability

As described above, the present invention is useful to radio IC devices used in RFID systems, and is particularly advantageous in miniaturization without reducing the radiation characteristics.

## Claims

1. An apparatus (180) having a radio IC device coupled to a metal component (181) thereof, the radio IC device comprising:
a radio IC (5) processing transmitted and received signals, and
a feed circuit (190) including a resonance circuit and/or a matching circuit and having an inductance element (191) electrically connected to or electromagnetically coupled to the radio IC (5);
wherein the feed circuit (190) is arranged such that the inductance element (191) of the feed circuit (190) is electromagnetically coupled to a radiation plate,
**characterized in that**
the metal component (181) is a ground electrode of the apparatus; and
the radiation plate is defined by the ground electrode without a dedicated antenna element for the transmitted and received signals being disposed as an additional independent component, and
the radiation plate comprises an opening (185, 185a) extending from an edge of the radiation plate, the surrounding of the opening (185, 185a) functioning as a loop electrode to which the radio IC (5) is electromagnetically coupled.

2. The apparatus (180) according to Claim 1, wherein the apparatus is a printed circuit board (180), and wherein the metal component is a ground electrode (111) on the printed circuit board (180).

3. The apparatus (180) according to Claim 2, wherein the inductance element (191) is defined by a coil, and wherein the coil is formed so as to be coupled with a magnetic field generated from the ground electrode (181) on the printed circuit board (180).

4. The apparatus (180) according to Claim 2 or 3, wherein the radio IC (5) and the feed circuit (190) are disposed together with another electronic component on the printed circuit board (180), and a case covers the radio IC (5), the feed circuit (190) and the electronic component.

## Patentansprüche

1. Eine Vorrichtung (180), die eine mit einer Metallkomponente (181) derselben gekoppelte Funk-IC-Vorrichtung aufweist, wobei die Funk-IC-Vorrichtung folgende Merkmale aufweist:
eine Funk-IC (5), die gesendete und empfangene Signale verarbeitet, und
eine Versorgungsschaltung (190), die eine Resonanzschaltung und/oder eine Anpassungsschaltung umfasst und ein Induktanzelement (191) aufweist, das mit der Funk-IC (5) elektrisch verbunden oder elektromagnetisch gekoppelt ist;
wobei die Versorgungsschaltung (190) derart angeordnet ist, dass das Induktanzelement (191) der Versorgungsschaltung (190) mit einer Strahlungsplatte elektromagnetisch gekoppelt ist,
**dadurch gekennzeichnet, dass**
die Metallkomponente (181) eine Masseelektrode der Vorrichtung ist; und
die Strahlungsplatte durch die Masseelektrode definiert ist, ohne dass ein zweckorientiertes Antennenelement für die gesendeten und empfangenen Signale als zusätzliche unabhängige Komponente angeordnet ist, und
die Strahlungsplatte eine Öffnung (185, 185a) aufweist, die sich von einer Kante der Strahlungsplatte erstreckt, wobei die Umgebung der Öffnung (185, 185a) als Schlingenelektrode fungiert, mit der die Funk-IC (5) elektromagnetisch gekoppelt ist.

2. Die Vorrichtung (180) gemäß Anspruch 1, wobei die Vorrichtung eine gedruckte Schaltungsplatine (180) ist und wobei die Metallkomponente eine Masseelektrode (111) auf der gedruckten Schaltungsplatine (180) ist.

3. Die Vorrichtung (180) gemäß Anspruch 2, bei der das Induktanzelement (191) durch eine Spule definiert ist und bei der die Spule dahin gehend gebildet ist, mit einem Magnetfeld gekoppelt zu sein, das aus der Masseelektrode (181) auf der gedruckten Schaltungsplatine (180) erzeugt wird.

4. Die Vorrichtung (180) gemäß Anspruch 2 oder 3, bei der die Funk-IC (5) und die Versorgungsschaltung (190) zusammen mit einer anderen elektronischen Komponente auf der gedruckten Schaltungsplatine (180) angeordnet sind und ein Gehäuse die Funk-IC (5), die Versorgungsschaltung (190) und die elektronische Komponente bedeckt.

## Revendications

1. Appareil (180) possédant un dispositif Cl radio couplé à un composant métallique (181) de celui-ci, le dispositif Cl radio comportant :
un Cl radio (5) traitant des signaux transmis et reçus, et
un circuit d'alimentation (190) comprenant un circuit résonnant et/ou un circuit d'adaptation et possédant un élément d'inductance (191) relié électriquement ou couplé électromagnétiquement au Cl radio (5) ;
dans lequel le circuit d'alimentation (190) est agencé de sorte que l'élément d'inductance (191) du circuit d'alimentation (190) est couplé électromagnétiquement à une plaque de rayonnement,
**caractérisé en ce que**
le composant métallique (181) est une électrode de masse de l'appareil ; et
la plaque de rayonnement est définie par l'électrode de masse sans élément d'antenne dédié pour les signaux reçus et transmis disposé en tant que composant indépendant supplémentaire, et
la plaque de rayonnement comporte une ouverture (185, 185a) s'étendant depuis un bord de la plaque de rayonnement, l'entourage de l'ouverture (185, 185a) fonctionnant en tant qu'électrode de boucle à laquelle le Cl radio (5) est couplé électromagnétiquement.

2. Appareil (180) selon la revendication 1, dans lequel l'appareil est une carte de circuit imprimé (180), et dans lequel le composant métallique est une électrode de masse (111) sur la carte de circuit imprimé (180).

3. Appareil (180) selon la revendication 2, dans lequel l'élément d'inductance (191) est défini par une bobine, et dans lequel la bobine est formée de manière à être couplée à un champ magnétique généré par l'électrode de masse (181) sur la carte de circuit imprimé (180).

4. Appareil (180) selon la revendication 2 ou 3, dans lequel le Cl radio (5) et le circuit d'alimentation (190) sont disposés conjointement avec un autre composant électronique sur la carte de circuit imprimé (180), et un boîtier recouvre le Cl radio (5), le circuit d'alimentation (190) et le composant électronique.
